# EUROPEAN PATENT APPLICATION

(11) **EP 4 618 085 A1**
(43) Date of publication of application: **17.09.2025**
(21) Application number: 23888471.2
(22) Date of filing: 23.10.2023
(51) Int. Cl.: G11C 11/16

(54) **STORAGE DEVICE, ELECTRONIC APPARATUS, AND METHOD FOR CONTROLLING STORAGE DEVICE**

(30) Priority: 07.11.2022 JP 2022178426
(71) Applicant: Sony Semiconductor Solutions Corporation, Atsugi-shi, Kanagawa 243-0014 (JP)
(72) Inventor: SAKAI, Lui, Atsugi-shi, Kanagawa 243-0014 (JP); HIGO, Yutaka, Atsugi-shi, Kanagawa 243-0014 (JP); MATSUMOTO, Rie, Tsukuba-shi, Ibaraki 305-8560 (JP); IMAMURA, Hiroshi, Tsukuba-shi, Ibaraki 305-8560 (JP); NOZAKI, Takayuki, Tsukuba-shi, Ibaraki 305-8560 (JP); HOSOMI, Masanori, Atsugi-shi, Kanagawa 243-0014 (JP); HIRAGA, Keizo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/038117
(87) International publication number: WO 2024/101120

(57) **Abstract**

A storage device according to an aspect of the present disclosure includes: a first magnetoresistive element that has a magnetization direction variable by voltage application and has a first retention force for retaining the magnetization direction; a second magnetoresistive element that has a magnetization direction variable by voltage application and has a second retention force for retaining the magnetization direction, the second retention force being lower than the first retention force; and a write unit that applies a voltage to the first magnetoresistive element by a first writing method and applies a voltage to the second magnetoresistive element by a second writing method different from the first writing method.

## Description

### Field

The present disclosure relates to a storage device, an electronic device, and a storage device control method.

### Background

Since a magnetoresistive random access memory (MRAM) using a magnetoresistive element as a storage element retains a state by a magnetization state of a ferromagnetic material, the magnetoresistive random access memory has non-volatility in which recorded data is retained even when a power supply is turned off. A basic structure of the magnetoresistive element is a sandwich structure in which a nonmagnetic thin film of an insulator is sandwiched between two magnetic layers made of a magnetic thin film. This structure is referred to as a magnetic tunnel junction (MTJ). Since a film thickness of the nonmagnetic thin film is as very thin as about several nm, when a voltage is applied to both ends of the element, a tunnel current flows. A magnitude of the tunnel current depends on a relative angle of magnetization of the two magnetic layers. This is called a tunnel magnetoresistance (TMR) effect.

In the MRAM, magnetization of one magnetic layer (magnetization fixed layer) of the two magnetic layers is fixed, and magnetization of the other magnetic layer (storage layer) is controlled by an external field. A state in which the magnetization of the magnetization fixed layer and the magnetization of the storage layer are parallel to each other is referred to as a state 0, and a state in which the magnetization of the magnetization fixed layer and the magnetization of the storage layer are antiparallel to each other is referred to as a state 1. In this way, the state ("0" or "1") is stored in a non-volatile manner by rewriting parallel/antiparallel states of magnetization. Examples of the external field used for the magnetization direction control include a current magnetic field generated by current energization to external wiring, a method in which current energization is directly performed to the MTJ to utilize a spin transfer torque (STT) effect, and a method in which magnetic anisotropy control by voltage (VCMA: voltage controlled magnetic anisotropy) is utilized. The TMR effect is used to read a state.

The currently mainstream MRAM is an STT-MRAM that can be made finer than using the current magnetic field and can reduce power consumption. On the other hand, a voltage controlled (VC) MRAM using VCMA, that is, a VC-MRAM has attracted attention because writing can be performed at a high speed and with lower power consumption. The VC-MRAM is non-volatile and has a small area similarly to the STT-MRAM, and the power consumption for writing is smaller than that of the STT-MRAM and is about a static random access memory (SRAM). The VC-MRAM is a non-volatile memory having a small area and power consumption.

The VC-MRAM utilizes the VCMA effect in which perpendicular magnetic anisotropy is changed by voltage application. When a magnetic field is applied in a horizontal direction of the magnetoresistive element of the VC-MRAM and the magnetic anisotropy in a vertical direction is reduced by the voltage application, a magnetization vector performs a precession motion about the magnetic field in the horizontal direction. When a pulse is cut at a timing when the magnetization vector is inverted by the precession motion, writing is successful.

In general, perpendicular magnetic anisotropy K (J/m³) and an applied voltage V (V) in the case where there is a VCMA effect are in a proportional relationship, and when the perpendicular magnetic anisotropy without voltage application is K^{pre}, K = K^{pre} - c × V can be represented. c (J/Vm³) is a proportionality factor. In addition, a retention characteristic (data retention characteristic) of retaining a magnetization direction (magnetization vector) is determined by the perpendicular magnetic anisotropy K^{pre} without voltage application. When c is not changed by increasing the retention characteristic, a voltage V₀ at which K = 0 is increased.

### Citation List

### Patent Literature

Patent Literature 1: JP 2020-205329 A

### Summary

### Technical Problem

As described above, when the retention characteristic of the magnetoresistive element of the VC-MRAM is increased, the voltage required for writing may also increase. This impairs the characteristic of the VC-MRAM with low power consumption. For example, Patent Literature 1 proposes a semiconductor storage device including two types of magnetoresistive memories (a first magnetoresistive memory and a second magnetoresistive memory). A coercive force (specifically, a coercive force of a free layer) of the first magnetoresistive memory is larger than a coercive force (specifically, a coercive force of a free layer) of the second magnetoresistive memory. A magnitude of the coercive force corresponds to a magnitude of the retention force for retaining the magnetization direction. In a case where the MRAM described in Patent Literature 1 is an STT-MRAM, write power consumption is large, and power consumption is large in an application that is frequently rewritten. In order to suppress this power consumption, even when the VC-MRAM is applied, it is necessary to apply a high voltage to an element having a high-retention characteristic. This impairs the characteristic of the VC-MRAM with low power consumption.

Therefore, the present disclosure provides a storage device, an electronic device, and a storage device control method capable of realizing low power consumption writing.

### Solution to Problem

A storage device according to an aspect of the present disclosure includes: a first magnetoresistive element that has a magnetization direction variable by voltage application and has a first retention force for retaining the magnetization direction; a second magnetoresistive element that has a magnetization direction variable by voltage application and has a second retention force for retaining the magnetization direction, the second retention force being lower than the first retention force; and a write unit that applies a voltage to the first magnetoresistive element by a first writing method and applies a voltage to the second magnetoresistive element by a second writing method different from the first writing method.

An electronic device according to an aspect of the present disclosure includes: a storage device that stores information, wherein the storage device includes a first magnetoresistive element that has a magnetization direction variable by voltage application and has a first retention force for retaining the magnetization direction, a second magnetoresistive element that has a magnetization direction variable by voltage application and has a second retention force for retaining the magnetization direction, the second retention force being lower than the first retention force, and a write unit that applies a voltage to the first magnetoresistive element by a first writing method and applies a voltage to the second magnetoresistive element by a second writing method different from the first writing method.

A storage device control method according to an aspect of the present disclosure includes: applying a voltage by a first writing method to a first magnetoresistive element that has a magnetization direction variable by voltage application and has a first retention force for retaining the magnetization direction; and applying a voltage by a second writing method different from the first writing method to a second magnetoresistive element that has a magnetization direction variable by voltage application and has a second retention force for retaining the magnetization direction, the second retention force being lower than the first retention force.

### Brief Description of Drawings

FIG. 1 is a diagram illustrating a configuration example of a memory system according to a first embodiment.
FIG. 2 is a diagram illustrating a first configuration example of a memory cell according to the first embodiment.
FIG. 3 is a diagram illustrating a second configuration example of the memory cell according to the first embodiment.
FIG. 4 is a diagram illustrating a first configuration example of a magnetoresistive element according to the first embodiment.
FIG. 5 is a diagram illustrating a second configuration example of the magnetoresistive element according to the first embodiment.
FIG. 6 is a diagram illustrating a relationship between perpendicular magnetic anisotropy and an applied voltage when there is a VCMA effect according to the first embodiment.
FIG. 7 is a diagram for explaining a low-retention element writing method (normal-voltage writing method) according to the first embodiment.
FIG. 8 is a diagram for explaining a simulation result of a write error rate by the low-retention element writing method according to the first embodiment.
FIG. 9 is a diagram for explaining a high-retention element writing method (low-voltage writing method) according to the first embodiment.
FIG. 10 is a diagram for explaining a simulation result of a write error rate by the high-retention element writing method according to the first embodiment.
FIG. 11 is a flowchart illustrating an example of a flow of write processing to a high-retention element according to the first embodiment.
FIG. 12 is a timing chart illustrating a timing of writing to the high-retention element according to the first embodiment.
FIG. 13 is a flowchart illustrating an example of a flow of write processing to a low-retention element according to the first embodiment.
FIG. 14 is a timing chart illustrating a timing of writing to the low-retention element according to the first embodiment.
FIG. 15 is a diagram illustrating a configuration example of a memory system according to a second embodiment.
FIG. 16 is a flowchart illustrating an example of a flow of write processing to a high-retention element according to the second embodiment.
FIG. 17 is a timing chart illustrating a timing of writing to the high-retention element or a low-retention element according to the second embodiment.
FIG. 18 is a diagram illustrating a configuration example of a memory system according to a third embodiment.
FIG. 19 is a timing chart illustrating a timing of writing to a high-retention element according to the third embodiment.
FIG. 20 is a diagram illustrating a configuration example of a memory system according to a fourth embodiment.
FIG. 21 is a diagram illustrating a configuration example of a memory system according to a fifth embodiment.
FIG. 22 is a diagram illustrating a configuration example of a memory system according to a sixth embodiment.
FIG. 23 is a diagram illustrating a configuration example of a memory system according to a seventh embodiment.
FIG. 24 is a diagram illustrating a configuration example of a memory system according to an eighth embodiment.
FIG. 25 is a diagram illustrating a configuration example of a memory system according to a ninth embodiment.
FIG. 26 is a diagram schematically illustrating a memory cell according to another embodiment.
FIG. 27 is a diagram illustrating a first relationship between a voltage and a current applied to a memory cell according to another embodiment.
FIG. 28 is a diagram illustrating a second relationship between a voltage and a current applied to a memory cell according to another embodiment.
FIG. 29 is a diagram for explaining a bit line voltage in a first example of a simulation result according to another embodiment.
FIG. 30 is a diagram for explaining a word line voltage in the first example of a simulation result according to another embodiment.
FIG. 31 is a diagram for explaining the first example of a simulation result according to another embodiment.
FIG. 32 is a diagram for explaining a bit line voltage in a second example of a simulation result according to another embodiment.
FIG. 33 is a diagram for explaining a word line voltage in the second example of a simulation result according to another embodiment.
FIG. 34 is a diagram for explaining the second example of a simulation result according to another embodiment.
FIG. 35 is a diagram for explaining a third example of a simulation result according to another embodiment.
FIG. 36 is a diagram for explaining a fourth example of a simulation result according to another embodiment.
FIG. 37 is a diagram for explaining an example of a magnetoresistive element writing method according to another embodiment.
FIG. 38 is a diagram for explaining a fifth example of a simulation result according to another embodiment.
FIG. 39 is a diagram for explaining a sixth example of a simulation result according to another embodiment.
FIG. 40 is a diagram for explaining a seventh example of a simulation result according to another embodiment.
FIG. 41 is a diagram for explaining an eighth example of a simulation result according to another embodiment.
FIG. 42 is a diagram illustrating a first example of a write pulse shape according to another embodiment.
FIG. 43 is a diagram illustrating a second example of a write pulse shape according to another embodiment.
FIG. 44 is a diagram illustrating a third example of a write pulse shape according to another embodiment.
FIG. 45 is a diagram illustrating a fourth example of a write pulse shape according to another embodiment.
FIG. 46 is a diagram illustrating a fifth example of a write pulse shape according to another embodiment.
FIG. 47 is a diagram illustrating a configuration example of an imaging device.
FIG. 48 is a diagram illustrating a configuration example of a distance measuring device.
FIG. 49 is a diagram illustrating an appearance example of a game device.
FIG. 50 is a diagram illustrating a configuration example of the game device.

### Description of Embodiments

Hereinafter, embodiments of the present disclosure will be described in detail with reference to the drawings. The embodiments also include examples, modifications, and the like. Note that the apparatus, device, method, and the like according to the present disclosure are not limited by the embodiments. In addition, in the following embodiments, the same reference numerals are given to basically the same parts, and redundant description is omitted.

The following one or a plurality of embodiments can each be implemented independently. On the other hand, the following plurality of embodiments may be implemented by appropriately combining at least a part thereof with at least a part of other embodiments. The plurality of embodiments may include novel features different from each other. Therefore, the embodiments can contribute to solving different objects or problems, and can exhibit different effects. Note that the effects in the embodiments are merely examples and are not limited, and other effects may be provided.

In addition, the drawings referred to in the following description are drawings for promoting the description and understanding of one embodiment of the present disclosure, and shapes, dimensions, ratios, and the like illustrated in the drawings may be different from actual ones for ease of understanding. Furthermore, the elements and the like illustrated in the drawings can be appropriately modified in design in consideration of the following description and known techniques. In addition, in the following description, a vertical direction of a laminated structure of an element and the like corresponds to a relative direction in a case where a surface on a substrate on which the element is provided is upward, and may be different from a vertical direction according to an actual gravitational acceleration.

In addition, in describing a magnetization direction (magnetic moment) and the magnetic anisotropy, terms such as a "perpendicular direction" (direction perpendicular to a film surface or laminating direction of a laminated structure) and an "in-plane direction" (a direction parallel to the film surface or a direction perpendicular to the laminating direction of the laminated structure) may be used for convenience. However, these terms do not necessarily mean the exact direction of magnetization. For example, wording such as "a magnetization direction is a perpendicular direction" or "having perpendicular magnetic anisotropy" means that magnetization in the perpendicular direction is superior to magnetization in the in-plane direction. Similarly, for example, wording such as "a magnetization direction is an in-plane direction" and "having in-plane magnetic anisotropy" mean that magnetization in the in-plane direction is superior to magnetization in the perpendicular direction.

The present disclosure will be described according to the following order of items.
1. First Embodiment
1-1. Configuration Example of Memory System
1-2. Configuration Example of Memory Cell
1-3. Configuration Example of Magnetoresistive Element
1-4. Writing Method
1-5. Write Processing
1-6. Action and Effect
2. Second Embodiment
2-1. Configuration Example of Memory System
2-2. Write Processing
2-3. Action and Effect
3. Third Embodiment
3-1. Configuration Example of Memory System
3-2. Write Processing
3-3. Action and Effect
4. Fourth Embodiment
4-1. Configuration Example of Memory System
4-2. Action and Effect
5. Fifth Embodiment
5-1. Configuration Example of Memory System
5-2. Action and Effect
6. Sixth Embodiment
6-1. Configuration Example of Memory System
6-2. Action and Effect
7. Seventh Embodiment
7-1. Configuration Example of Memory System
7-2. Action and Effect
8. Eighth Embodiment
8-1. Configuration Example of Memory System
8-2. Action and Effect
9. Ninth Embodiment
9-1. Configuration Example of Memory System
9-2. Action and Effect
10. Other Embodiments
10-1. Writing Method Using Rectangular Pulse
10-2. Simulation Results
10-3. Writing Method Using Non-Rectangular Pulse
11. Configuration Example of Electronic Device
11-1. Imaging Device
11-2. Distance Measuring Device
11-3. Game Device
12. Appendix

### <1. First Embodiment>

### <1-1. Configuration Example of Memory System>

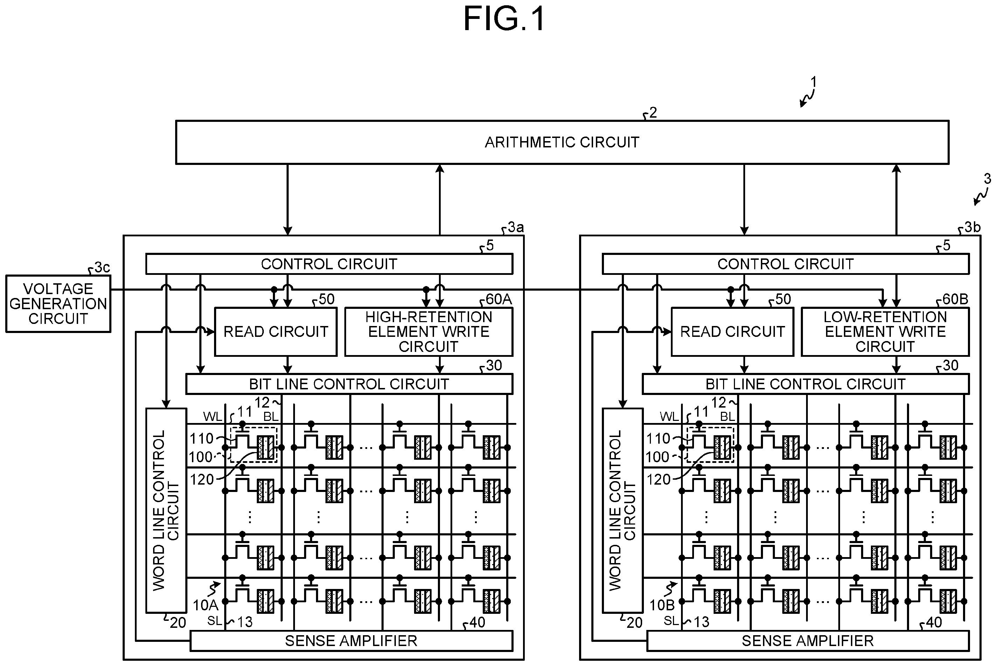

A configuration example of a memory system 1 according to a first embodiment will be described with reference to FIG. 1. FIG. 1 is a diagram illustrating a configuration example of the memory system 1 according to the first embodiment. The memory system 1 is applied to, for example, a large-scale integrated circuit (LSI).

As illustrated in FIG. 1, the memory system 1 according to the first embodiment includes an arithmetic circuit (arithmetic device) 2 and a storage device 3. The storage device 3 is an example of a storage device that retains information according to a magnetization direction of a magnetic body.

The arithmetic circuit 2 performs, for example, a logical operation such as artificial intelligence (AI), a recognition function, or machine learning. The arithmetic circuit 2 performs, for example, various types of arithmetic processing based on a program. Note that programs, various types of setting values, and the like are stored in the storage device 3 for a long period of time, and data generated by the arithmetic processing and the like are stored in the storage device 3 for a short period of time.

The storage device 3 includes two storage circuits (storage units) 3a and 3b and a voltage generation circuit 3c.

The storage circuit 3a is a memory capable of retaining data for a long period of time (a memory having high-retention characteristic). As the storage circuit 3a, for example, a memory is used which has a low rewriting frequency, does not lose data even when a power supply is turned off, and can retain data for a long period of time in order to store programs, various types of setting values, and learning data of recognition processing.

The storage circuit 3b is a memory capable of retaining data for a short period of time (a memory having a low-retention characteristic) than the storage circuit 3a. As the storage circuit 3b, for example, a memory capable of retaining data for a short period of time is used which has a high rewriting frequency but a short time from writing to reading for temporary storage of calculation process data, streaming data, data generated by recognition processing, or the like.

The voltage generation circuit 3c is a circuit that generates a voltage used at the time of writing and reading data to and from the two storage circuits 3a and 3b. The voltage generation circuit 3c is common to the two storage circuits 3a and 3b.

### (Two Storage Circuits)

The storage circuit 3a includes a control circuit 5, a high-retention memory cell array 10A, a word line control circuit 20, a bit line control circuit 30, a sense amplifier 40, a read circuit 50, and a high-retention element write circuit 60A.

The storage circuit 3b includes a control circuit 5, a low-retention memory cell array 10B, a word line control circuit 20, a bit line control circuit 30, a sense amplifier 40, a read circuit 50, and a low-retention element write circuit 60B.

The storage circuit 3b has the same control circuit 5, word line control circuit 20, bit line control circuit 30, sense amplifier 40, and read circuit 50 as the storage circuit 3a, but is different in that it has a low-retention memory cell array 10B and a low-retention element write circuit 60B instead of the high-retention memory cell array 10A and the high-retention element write circuit 60A.

The control circuit 5 performs processing of a write/read command from the arithmetic circuit 2 and control of data input/output. For example, the control circuit 5 receives a command (a command such as writing or reading) from the arithmetic circuit 2, and controls writing or reading of data based on the received command.

Each of the high-retention memory cell array 10A and the low-retention memory cell array 10B is configured by arranging memory cells 100 that store data in a two-dimensional matrix. The memory cell 100 includes a selection element 110 and a magnetoresistive element 120. For example, a VC-MRAM cell can be used as the memory cell 100. The selection element 110 is an element that is connected to one end of the magnetoresistive element 120 and controls application of a voltage to the magnetoresistive element 120. As the selection element 110, for example, an n-channel MOS transistor can be used. Furthermore, as the magnetoresistive element 120, for example, a magnetoresistive element such as an MTJ can be used.

Here, each magnetoresistive element 120 of the high-retention memory cell array 10A is a high-retention element having a high retention force (high perpendicular magnetic anisotropy) for retaining the magnetization direction. That is, the high-retention element is the magnetoresistive element 120 having a high retention characteristic, and is, for example, the magnetoresistive element 120 for long-term retention that stores data such as programs and various types of setting values for a long period of time. In addition, each magnetoresistive element 120 of the low-retention memory cell array 10B is a low-retention element having a low retention force (low perpendicular magnetic anisotropy) lower than the retention force of the high-retention element. The low-retention element is the magnetoresistive element 120 having a low retention characteristic, and is, for example, the magnetoresistive element 120 for short-term retention that temporarily stores data being processed such as arithmetic processing. Note that the magnetization direction of the magnetoresistive element 120 is variable between a first state and a second state (for example, state 0 and state 1) by voltage application. Therefore, retaining the magnetization direction means retaining the magnetization direction in the first state or the second state. The magnetoresistive element 120 will be described later in detail.

A word line 11 (WL) and a bit line 12 (BL) for transmitting a control signal are connected to the memory cell 100. In the memory cell 100, a source line 13 (SL) for transmitting a signal from the magnetoresistive element 120 is further disposed. In the memory cell array 10, a plurality of word lines 11 are wired so as to extend in a row direction, and a plurality of bit lines 12 and source lines 13 are wired so as to extend in a column direction.

The word line control circuit 20 controls a word line voltage according to a designated address. For example, the word line control circuit 20 selects the word line 11 in response to the designated address and outputs a control signal to the selected word line 11.

The bit line control circuit 30 controls a bit line voltage according to a designated address. For example, the bit line control circuit 30 selects the bit line 12 in response to the designated address, and outputs a control signal to the selected bit line 12.

The sense amplifier 40 determines a read signal. For example, the sense amplifier 40 reads data by detecting a current flowing through the memory cell 100 at the time of reading. For example, the read data is output to the read circuit 50 and input to the control circuit 5 via the read circuit 50.

The read circuit 50 controls data read processing. For example, the read circuit 50 is a circuit that performs reading with respect to the memory cell 100 at an intersection of the selected word line 11 and bit line 12. The read circuit 50 reads the magnetoresistive element 120 via the selection element 110 of the memory cell 100. The reading can be performed by applying a predetermined read voltage to the magnetoresistive element 120 of the memory cell 100 and detecting a current flowing through the memory cell 100. The read voltage is preferably a voltage having a polarity different from that of a write voltage.

The high-retention element write circuit 60A controls data write processing to the high-retention memory cell array 10A. For example, the high-retention element write circuit 60A is a circuit that performs writing on the memory cell 100 at the intersection of the selected word line 11 and bit line 12 in the high-retention memory cell array 10A. The high-retention element write circuit 60A performs writing on the magnetoresistive element 120 via the selection element 110 of the memory cell 100. Writing can be performed by applying a predetermined write voltage (voltage based on a high-retention element writing method) to the magnetoresistive element 120 of the memory cell 100.

The low-retention element write circuit 60B controls data write processing to the low-retention memory cell array 10B. For example, the low-retention element write circuit 60B is a circuit that performs writing on the memory cell 100 at the intersection of the selected word line 11 and bit line 12 in the low-retention memory cell array 10B. The low-retention element write circuit 60B performs writing on the magnetoresistive element 120 via the selection element 110 of the memory cell 100. The writing can be performed by applying a predetermined write voltage (voltage based on a low-retention element writing method) to the magnetoresistive element 120 of the memory cell 100, similarly to the high-retention element write circuit 60A.

Here, the high-retention element write circuit 60A, the low-retention element write circuit 60B, and the voltage generation circuit 3c function as a write unit. The write unit applies a voltage to each magnetoresistive element 120 of the high-retention memory cell array 10A of the storage circuit 3a, that is, each high-retention element by a high-retention element writing method, and applies a voltage to each magnetoresistive element 120 of the low-retention memory cell array 10B of the storage circuit 3b, that is, each low-retention element by a low-retention element writing method. The high-retention element writing method and the low-retention element writing method will be described later in detail.

As the write circuit, for example, different circuits are used for the storage circuit 3a including the high-retention memory cell array 10A and the storage circuit 3b including the low-retention memory cell array 10B, like the high-retention element write circuit 60A and the low-retention element write circuit 60B. On the other hand, as the write voltage, for example, the same voltage generated by the voltage generation circuit 3c common to the storage circuit 3a including the high-retention memory cell array 10A and the storage circuit 3b including the low-retention memory cell array 10B is used.

### <1-2. Configuration Example of Memory Cell>

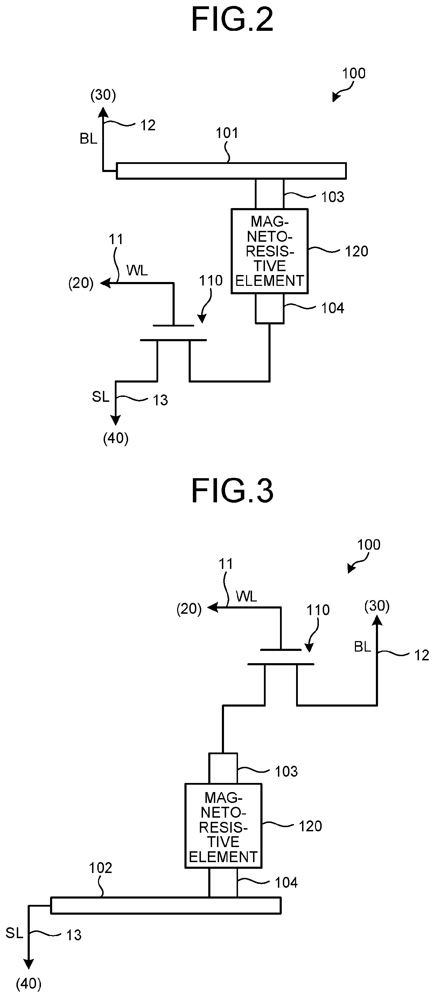

A configuration example of the memory cell 100 according to the first embodiment will be described with reference to FIGS. 2 and 3. FIGS. 2 and 3 are diagrams illustrating configuration examples of the memory cell 100 according to the first embodiment, respectively. Each drawing is a schematic diagram representing a configuration example of the memory cell 100. As described above, the memory cell 100 includes the selection element 110 and the magnetoresistive element 120. In the examples of FIGS. 2 and 3, the selection element 110 and the magnetoresistive element 120 are connected in series, and the selection element 110 has a drain (drain terminal), a source (source terminal), and a gate (gate terminal).

As illustrated in FIG. 2, the magnetoresistive element 120 of the memory cell 100 is connected to a wiring 101 via a contact layer 103, and is connected to the selection element 110 via a contact layer 104. A drain of the selection element 110 is connected to the contact layer 104, and a source thereof is connected to the source line 13 (SL). A gate of the selection element 110 is connected to the word line 11 (WL). Note that the contact layer 103 is connected to the wiring 101 configuring the bit line 12 (BL). By applying an on-voltage to the word line 11 (WL), the selection element 110 is conducted, and a voltage can be applied to the magnetoresistive element 120.

As illustrated in FIG. 3, the magnetoresistive element 120 of the memory cell 100 is connected to a wiring 102 via the contact layer 104, and is connected to the selection element 110 via the contact layer 103. The selection element 110 has a drain connected to the bit line 12 (BL) and a source connected to the contact layer 103. The gate of the selection element 110 is connected to the word line 11 (WL). Note that the contact layer 104 is connected to the wiring 102 configuring the source line 13 (SL). By applying an on-voltage to the word line 11 (WL), the selection element 110 is conducted, and a voltage can be applied to the magnetoresistive element 120.

As described above, the word line 11 (WL) is connected to the word line control circuit 20 (see FIG. 1). The bit line 12 (BL) is connected to the bit line control circuit 30 (see FIG. 1). The source line 13 (SL) is connected to the sense amplifier 40 (see FIG. 1). By applying a voltage between the bit line 12 (BL) and the source line 13 (SL) and applying an on-voltage for conducting the selection element 110 to the word line 11 (WL), a voltage for writing or reading can be applied to the magnetoresistive element 120.

### <1-3. Configuration Example of Magnetoresistive Element>

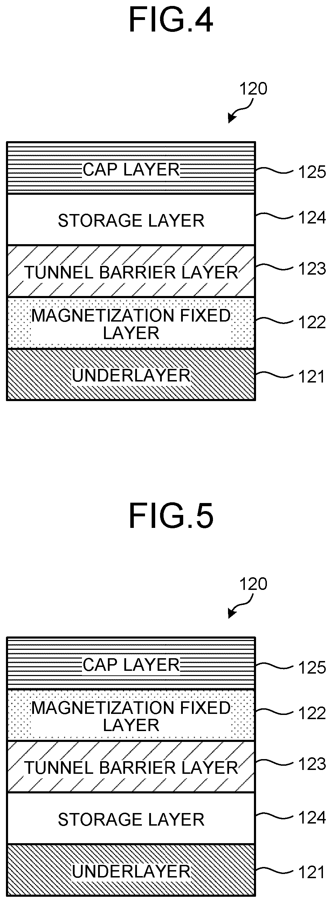

A configuration example of the magnetoresistive element 120 according to the first embodiment will be described with reference to FIGS. 4 and 5. FIGS. 4 and 5 are diagrams each illustrating a configuration example of the magnetoresistive element 120 according to the first embodiment, respectively. Each drawing is a cross-sectional diagram representing a configuration example of the magnetoresistive element 120.

As illustrated in FIGS. 4 and 5, the magnetoresistive element 120 includes an underlayer 121, a magnetization fixed layer 122, a tunnel barrier layer 123, a storage layer 124, and a cap layer 125. The magnetoresistive element 120 illustrated in FIG. 4 is configured by sequentially laminating the underlayer 121, the magnetization fixed layer 122, the tunnel barrier layer 123, the storage layer 124, and the cap layer 125. On the other hand, the magnetoresistive element 120 illustrated in FIG. 5 is configured by sequentially laminating the underlayer 121, the storage layer 124, the tunnel barrier layer 123, the magnetization fixed layer 122, and the cap layer 125.

As the underlayer 121, for example, a layer formed of a noble metal such as Cr, Ta, Ru, Au, Ag, Cu, Al, Ti, V, Mo, Zr, Hf, Re, W, Pt, Pd, Ir, or Rh or a transition metal element, and a laminated structure thereof can be used. The underlayer 121 can also be made of a conductive nitride such as TiN. For example, the underlayer 121 is configured by a film for improving crystal orientation control of the magnetization fixed layer 122 and adhesion strength to a lower electrode.

The magnetization fixed layer 122 is a layer having magnetic anisotropy and a constant magnetization direction. The magnetization fixed layer 122 can be made of, for example, CoFeB, a CoFeC alloy, a NiFeB alloy, a NiFeC alloy, or the like. Furthermore, the magnetization fixed layer 122 can have a laminated ferri-pin structure in which a plurality of ferromagnetic layers are laminated with a nonmagnetic layer interposed therebetween. As a material of the ferromagnetic layer configuring the magnetization fixed layer 122 having the laminated ferri-pin structure, Co, CoFe, CoFeB, or the like can be used. As a material of the nonmagnetic layer, Ru, Re, Ir, Os, or the like can be used.

Furthermore, the magnetization fixed layer 122 can have a configuration in which the magnetization direction is fixed by using antiferromagnetic coupling between the antiferromagnetic layer and the ferromagnetic layer. Examples of the material of the antiferromagnetic layer include magnetic bodies such as an FeMn alloy, a PtMn alloy, a PtCrMn alloy, an NiMn alloy, an IrMn alloy, NiO, and Fe2O3. In addition, a nonmagnetic element such as Ag, Cu, Au, Al, Si, Bi, Ta, B, C, O, N, Pd, Pt, Zr, Hf, Ir, W, Mo, or Nb can be added to these magnetic bodies.

The tunnel barrier layer 123 is disposed adjacent to the storage layer 124 to be described later, and applies an electric field to the storage layer 124 to impart a voltage controlled magnetic anisotropy effect. The tunnel barrier layer 123 can be made of an oxide of at least one type of element selected from the group consisting of Mg, Al, Ti, Si, Zn, Zr, Hf, Ta, Bi, Cr, Ga, La, Gd, Sr, and Ba, or a nitride of at least one type of element selected from the group consisting of Mg, Al, Ti, Si, Zn, Zr, Hf, Ta, Bi, Cr, Ga, La, Gd, Sr, and Ba. In addition, it can also be configured by using an insulator such as MgF2, CaF, SrTiO2, AlLaO3, or AlNO, a dielectric, and a semiconductor. These layers may also be formed into a laminated structure. A thickness of the tunnel barrier layer 123 is preferably 0.6 nm or more.

The storage layer 124 is a layer having magnetic anisotropy and a variable magnetization direction. In addition, the storage layer 124 is a layer having the VCMA effect. A state in which the magnetization direction of the storage layer 124 is the same as and different from the magnetization direction of the magnetization fixed layer 122 are referred to as a parallel state and an antiparallel state, respectively. The magnetoresistive element 120 is in a low resistance state in the parallel state, and is in a high resistance state in the antiparallel state. By applying a voltage to the magnetoresistive element 120 as described above, the magnetization direction of the storage layer 124 can be changed.

In addition, the storage layer 124 can be made of cobalt iron (CoFe), cobalt iron boron (CoFeB), Fe, iron boride (FeB), or the like. In addition, it is also possible to adopt a configuration including a transition metal (Hf, Ta, W, Re, Ir, Pt, Au, Zr, Nb, Mo, Ru, Rh, Pd, Ag, Ti, V, Cr, Mn, Ni, or Cu) or the like. In addition, a nitride or an oxide may be contained. In addition, iridium (Ir) or osmium (Os) can be used as a material that induces a proximity magnetic moment to the magnetic body. A heavy metal can be added to the storage layer 124 to improve the voltage controlled magnetic anisotropy effect. A thickness of the storage layer 124 is preferably 3.0 nm or less.

Furthermore, the storage layer 124 may have a laminated structure in which a plurality of ferromagnetic layers are laminated with a nonmagnetic layer interposed therebetween. At this time, two ferromagnetic layers adjacent to each other with the nonmagnetic layer interposed therebetween may be exchange-coupled. The nonmagnetic layer can be made of Mg, Al, Ti, Si, Zn, Zr, Hf, Ta, Bi, Cr, Ga, La, Gd, Sr, Ba, W, Re, Ir, Pt, Au, Nb, Mo, Ru, Rh, Pd, Ag, V, Mn, Ni, Cu, or the like.

The cap layer 125 is a layer that prevents diffusion of metal from a wiring member. The cap layer 125 can be made of a metal such as Cr, Ta, Ru, Au, Ag, Cu, Al, Ti, V, Mo, Zr, Hf, Re, W, Pt, Pd, Ir, or Rh. In addition, the cap layer 125 can be configured by a layer including an alloy or a transition metal element containing these elements. Furthermore, the cap layer 125 can also be configured by laminating these elements. The cap layer 125 can also be made of a conductive nitride such as TiN.

The various layers described above can be produced by, for example, a physical vapor deposition (PVD) method typified by a sputtering method, an ion beam deposition method, and a vacuum vapor deposition method, and a chemical vapor deposition (CVD) method typified by an atomic layer deposition (ALD) method. Patterning of these layers can be performed by a reactive ion etching (RIE) method or an ion milling method. The various layers are preferably formed continuously in a vacuum apparatus and then preferably patterned.

A retention force (retention force for retaining the magnetization direction) of the magnetoresistive element 120 having such a configuration changes according to a coercive force of the magnetoresistive element 120 (specifically, the storage layer 14), for example. The coercive force of the magnetoresistive element 120 increases as a volume of the magnetoresistive element 120, that is, a total volume of the layers of the magnetization fixed layer 122, the tunnel barrier layer 123, and the storage layer 124 increases. Thicknesses and areas (areas in a plane direction orthogonal to a thickness direction) of the magnetization fixed layer 122, the tunnel barrier layer 123, and the storage layer 124 are adjusted, and the retention force of the magnetoresistive element 120 is changed. As a result, a plurality of magnetoresistive elements 120 having different retention forces can be obtained.

### <1-4. Writing Method>

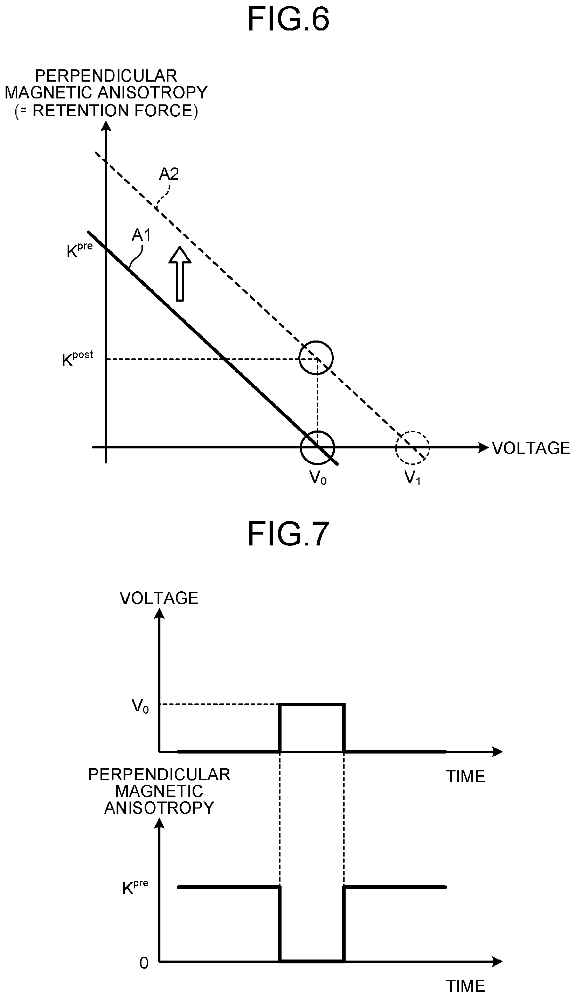

A writing method according to the first embodiment will be described with reference to FIGS. 6 to 10. As the writing method, there are a low-retention element writing method (normal-voltage writing method) and a high-retention element writing method (low-voltage writing method). The low-retention element writing method corresponds to a second writing method, and the high-retention element writing method corresponds to a first writing method.

### (Relationship between Perpendicular Magnetic Anisotropy and Applied Voltage When There Is VCMA Effect)

FIG. 6 is a diagram illustrating a relationship between the perpendicular magnetic anisotropy and the applied voltage in a case where there is a VCMA effect according to the first embodiment. As illustrated in FIG. 6, perpendicular magnetic anisotropy K (J/m³) and an applied voltage V (V) in the case there is a VCMA effect are in a proportional relationship, and when the perpendicular magnetic anisotropy without voltage application is K^{pre}, K = K^{pre} - c × V (see a graph A1 in FIG. 6) can be represented. c (J/Vm³) is a proportionality factor. The retention force (retention characteristic) for retaining the magnetization direction is determined by the perpendicular magnetic anisotropy K^{pre} without voltage application. In the example of FIG. 6, a voltage at which K = 0 in the graph A1 is V₀, but a voltage at which K = 0 in a graph A2 in a case where the perpendicular magnetic anisotropy K^{pre}, that is, the retention characteristic is increased and c is not different from that in the graph A1, is larger than V₀ and becomes V₁.

### (Low-Retention Element Writing Method)

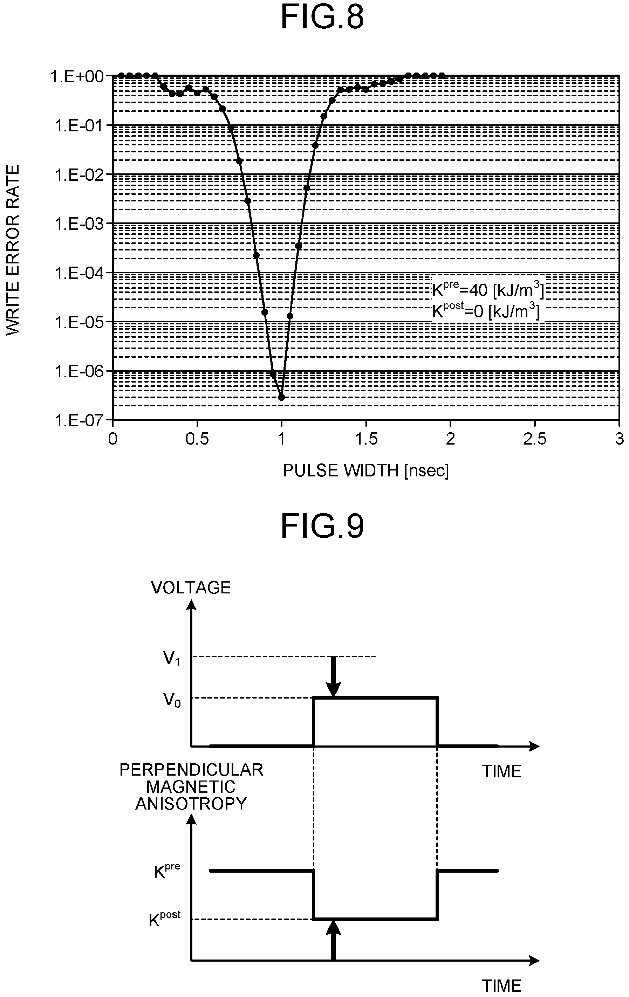

FIG. 7 is a diagram for explaining a low-retention element writing method (normal-voltage writing method) according to the first embodiment. FIG. 8 is a diagram for explaining a simulation result of a write error rate by the low-retention element writing method according to the first embodiment.

In the low-retention element writing method, when the perpendicular magnetic anisotropy during voltage application is K^{post} (see FIG. 6), the low-retention element write circuit 60B applies a voltage V₀ at which K^{post} = 0 as a write pulse as illustrated in FIG. 7. Here, for example, FIG. 8 illustrates a simulation result of a write error rate at K^{pre} = 40 (kJ/m³) and K^{post} = 0 (kJ/m³).

As illustrated in FIG. 8, a pulse width has an optimum value. In the example of FIG. 8, it is desirable to apply a pulse of about 1 (nsec) having a smallest write error rate. Note that the low-retention element writing method is, for example, a method of applying a voltage for setting the perpendicular magnetic anisotropy K^{post} (retention force) of the low-retention element during voltage application to 0 to the low-retention element.

### (High-Retention Element Writing Method)

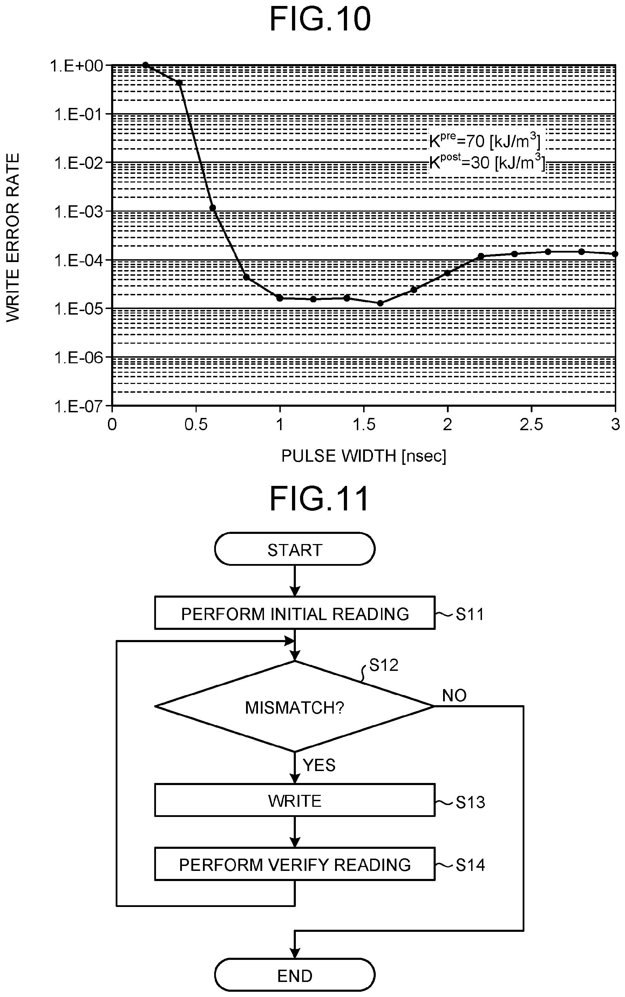

FIG. 9 is a diagram for explaining a high-retention element writing method (low-voltage writing method) according to the first embodiment. FIG. 10 is a diagram for explaining a simulation result of a write error rate by the high-retention element writing method according to the first embodiment.

In the high-retention element writing method, when the perpendicular magnetic anisotropy during voltage application is K^{post} (see FIG. 6), the high-retention element write circuit 60A applies a voltage satisfying K^{pre} > K^{post} > 0 as a write pulse as illustrated in FIG. 9. Here, for example, FIG. 10 illustrates a simulation result of a write error rate at K^{pre} = 70 (kJ/m³) and K^{post} = 33 (kJ/m³).

In FIGS. 8 and 10, the perpendicular magnetic anisotropy when no voltage is applied is K^{pre} = 40 (kJ/m³) in FIG. 8 and K^{pre} = 70 (kJ/m³) in FIG. 10, and the retention characteristic is higher in FIG. 10. Here, when c is the same, a voltage V₁ (see FIG. 6) larger than the voltage V₀ at which K^{post} = 0 is satisfied for a low-retention element of K^{pre} = 30 (kJ/m³) is required for a voltage at which K^{post} = 0 is satisfied for a high-retention element of K^{pre} = 70 (kJ/m³). However, since the high-retention element can be reversed (change in magnetization direction) at K^{post} = 30 (kJ/m³), when the high-retention element writing method is applied to the high-retention element of K^{pre} = 70 (kJ/m³), the voltage becomes smaller than that when the low-retention element writing method (normal-voltage writing method) is applied.

Specifically, from K = K^{pre} - c × V, the voltage in a case of applying the low-retention element writing method to the low-retention element of K^{pre} = 40 (kJ/m³) is 40/c (kV), and the voltage in a case of applying the low-retention element writing method to the low-retention element of K^{pre} = 70 (kJ/m³) is 70/c (kV). On the other hand, the voltage in a case of applying the high-retention element writing method to the high-retention element of K^{pre} = 70 (kJ/m³) is 40/c (kV). As described above, the same voltage can be used in a case of applying the low-retention element writing method to the low-retention element and in a case of applying the high-retention element writing method to the high-retention element.

Note that the high-retention element writing method is, for example, a method in which a voltage that makes the perpendicular magnetic anisotropy K^{post} (retention force) of the high-retention element during voltage application smaller than that before voltage application (perpendicular magnetic anisotropy K^{pre} without voltage application) and larger than 0 is applied to the high-retention element (first magnetoresistive element 120). This high-retention element writing method is described in, for example, "Voltage-induced switching with long tolerance of voltage-pulse duration in a perpendicularly magnetized free layer, Rie Matsumoto, Applied Physics Express (2019)".

### <1-5. Write Processing>

The write processing according to the first embodiment will be described with reference to FIGS. 11 to 14.

### (Write Processing to High-Retention Element)

FIG. 11 is a flowchart illustrating an example of a flow of write processing to the high-retention element according to the first embodiment. In the example of FIG. 11, writing to the high-retention element is executed based on the high-retention element writing method.

As illustrated in FIG. 11, in step S11, the read circuit 50 of the storage circuit 3a performs initial reading. After the initial reading, in step S12, the control circuit 5 of the storage circuit 3a determines whether or not the read data and the write data are mismatched, and when it is determined that those pieces of data are not mismatched (matched) (No in step S12), the processing ends. On the other hand, when the control circuit 5 of the storage circuit 3a determines that those pieces of data are mismatched (Yes in step S12), in step S13, the high-retention element write circuit 60A of the storage circuit 3a writes to the high-retention element (high-retention memory cell array 10A). After the writing, in step S14, the read circuit 50 of the storage circuit 3a performs verify reading, and the processing returns to step S12. Thereafter, step S12 and subsequent processing is repeated. For example, when the read data and the write data are matched, the processing ends, and when the read data and the write data are mismatched, the writing is repeated.

In this way, after the initial reading, when the read data and the write data are matched, the processing ends, and when the read data and the write data are not matched, writing is performed, and then the verify processing is executed. The high-retention element (the magnetoresistive element 120 having a high retention characteristic) records, for example, data such as learning data of recognition processing. For this reason, for example, it is possible to record data in advance of the recognition processing, and it is possible to take a long write time such as a plurality of times of verification. The example of FIG. 10 indicates an error rate of one-time writing, but the write error rate can be lowered by performing writing a plurality of times.

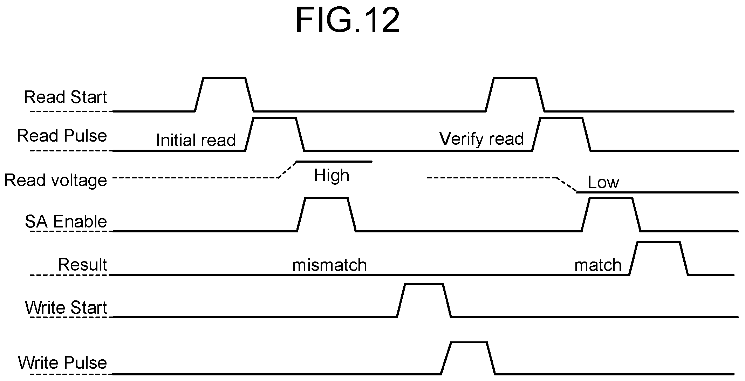

FIG. 12 is a timing chart illustrating a timing of writing to the high-retention element according to the first embodiment. In the example of FIG. 12, an example of writing from high resistance to low resistance is indicated. Note that by switching a level of an electric resistance value of the high-retention element (magnetic tunnel junction), 1-bit information (for example, 0 or 1) can be stored in the high-retention element.

As illustrated in FIG. 12, the read circuit 50 of the storage circuit 3a issues a read pulse (Read Pulse: Initial read) in response to a read start signal (Read Start) from the control circuit 5 of the storage circuit 3a. Since a read potential (Read voltage) changes according to the recording state, the read potential is detected by the sense amplifier 40 of the storage circuit 3a at the time point when the potential is determined. When the read data and the write data are not matched by comparison (Result: mismatch), the high-retention element write circuit 60A of the storage circuit 3a issues a write pulse (Write Pulse) based on the high-retention element writing method in response to a write start signal (Write Start) from the control circuit 5 of the storage circuit 3a. When the write pulse ends, the read circuit 50 of the storage circuit 3a issues a read pulse (Read Pulse: Verify read) in response to the read start signal (Read Start) from the control circuit 5 of the storage circuit 3a for verification. When the read data and the write data are matched by comparison (Result: match), the processing ends.

### (Write Processing to Low-Retention Element)

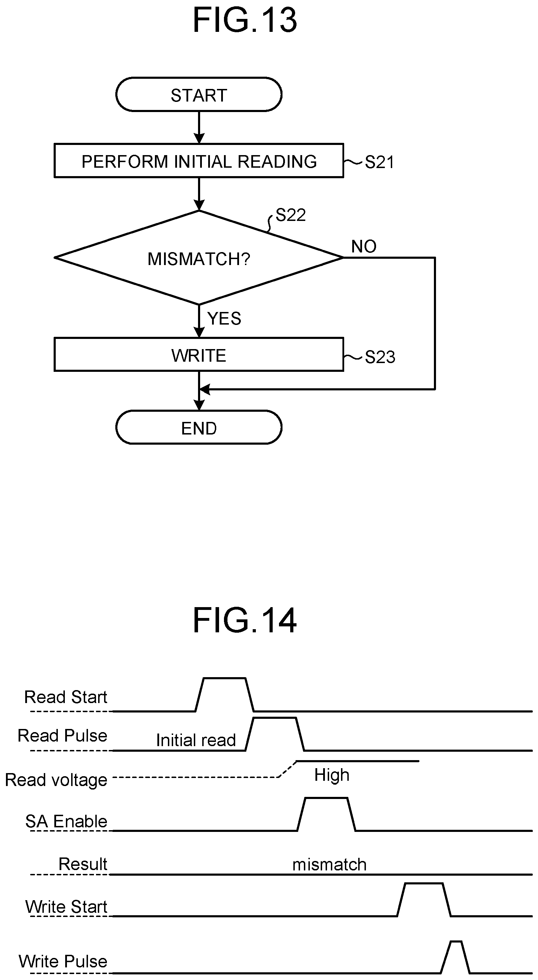

FIG. 13 is a flowchart illustrating an example of a flow of write processing to the low-retention element according to the first embodiment. In the example of FIG. 13, writing to the low-retention element is performed using a normal-voltage writing method.

As illustrated in FIG. 13, in step S21, the read circuit 50 of the storage circuit 3b performs initial reading. After the initial reading, in step S22, the control circuit 5 of the storage circuit 3a determines whether or not the read data and the write data are mismatched, and when it is determined that those pieces of data are not mismatched (matched) (No in step S22), the processing ends. On the other hand, when the control circuit 5 of the storage circuit 3b determines that those pieces of data are mismatched (Yes in step S22), in step S23, the low-retention element write circuit 60B of the storage circuit 3b writes to the low-retention element (low-retention memory cell array 10B).

In this way, after the initial reading, when the read data and the write data are matched, the processing ends, and when the read data and the write data are not matched, writing is performed. The low-retention element (the magnetoresistive element 120 having a low-retention characteristic) desirably has a low delay in order to record data, for example, from a recognition processing process. Therefore, in the example of FIG. 13, verification is not performed.

FIG. 14 is a timing chart illustrating a timing of writing to the low-retention element according to the first embodiment. In the example of FIG. 14, an example of writing from low resistance to high resistance is indicated. Note that similarly to the high-retention element, by switching a level of an electric resistance value of the low-retention element (magnetic tunnel junction), 1-bit information (for example, 0 or 1) can be stored in the low-retention element.

As illustrated in FIG. 14, the read circuit 50 of the storage circuit 3b issues a read pulse (Read Pulse: Initial read) in response to a read start signal (Read Start) from the control circuit 5 of the storage circuit 3b. Since a read potential (Read voltage) changes according to the recording state, the read potential is detected by the sense amplifier 40 of the storage circuit 3b at the time point when the potential is determined. When the read data and the write data are not matched by comparison (Result: mismatch), the low-retention element write circuit 60B of the storage circuit 3b issues a write pulse (Write Pulse) based on the low-retention element writing method in response to a write start signal (Write Start) from the control circuit 5 of the storage circuit 3b. The writing to the low-retention element is completed without verification. Since a low-retention element writing method is used in the writing to the low-retention element, it is desirable to apply a write pulse having a short pulse width. Therefore, in the example of FIG. 14, a write pulse having a shorter pulse width than the example of FIG. 12 is illustrated.

As described above, in a case where both the high-retention element and the low-retention element are mounted, it is possible to reduce the write voltage to the high-retention element by applying different writing methods to these elements, and thus, it is possible to realize low power consumption writing. In addition, when the write voltages to the high-retention element and the low-retention element can be made the same, it is not necessary to generate a plurality of write voltages, that is, it is not necessary to provide a plurality of voltage generation circuits, and the circuit scale can be reduced. In addition, a write error rate of the high-retention element can be reduced by retrying writing to the high-retention element.

### <1-6. Action and Effect>

As described above, according to the first embodiment, a storage device 3 includes a first magnetoresistive element 120 (for example, high-retention element) that has a magnetization direction variable by voltage application and has a first retention force for retaining the magnetization direction; a second magnetoresistive element 120 (for example, low-retention element) that has a magnetization direction variable by voltage application and has a second retention force for retaining the magnetization direction, the second retention force being lower than the first retention force; and a write unit that applies a voltage to the first magnetoresistive element 120 by a first writing method and applies a voltage to the second magnetoresistive element 120 by a second writing method different from the first writing method. Thus, by applying different writing methods to the first magnetoresistive element 120 and the second magnetoresistive element 120, the write voltage to the first magnetoresistive element 120 can be reduced, so that low power consumption writing can be realized.

In addition, the write unit may include a voltage generation circuit 3c that generates a voltage, a first write circuit (for example, high-retention element write circuit 60A) that applies the voltage generated by the voltage generation circuit 3c to the first magnetoresistive element 120 by the first writing method, and a second write circuit (for example, low-retention element write circuit 60B) that applies the voltage generated by the voltage generation circuit 3c to the second magnetoresistive element 120 by the second writing method. As a result, it is sufficient to provide one voltage generation circuit 3c, and it is not necessary to provide a voltage generation circuit for each of the first magnetoresistive element 120 and the second magnetoresistive element 120, so that the circuit scale can be reduced.

In addition, the first writing method may be a method of applying, to the first magnetoresistive element 120, a voltage that makes the first retention force of the first magnetoresistive element 120 during voltage application smaller than that before voltage application and larger than 0, and the second writing method may be a method of applying, to the second magnetoresistive element 120, a voltage that makes the second retention force of the second magnetoresistive element 120 during voltage application 0. As a result, low power consumption writing can be reliably realized.

Further, a pulse width of the voltage applied to the first magnetoresistive element 120 may be different from a pulse width of the voltage applied to the second magnetoresistive element 120. As a result, since the pulse width can be adjusted, it is possible to suppress a delay related to writing while realizing low power consumption writing.

The pulse width of the voltage applied to the second magnetoresistive element 120 may be shorter (narrower) than the pulse width of the voltage applied to the first magnetoresistive element 120. This makes it possible to reliably suppress a delay related to writing to the second magnetoresistive element 120.

In addition, in a case where a magnetic direction of the first magnetoresistive element 120 is not a desired state after applying a voltage to the first magnetoresistive element 120 by the first writing method, the write unit may apply a voltage to the first magnetoresistive element 120 again by the first writing method. Thus, a write error rate of the first magnetoresistive element 120 can be reduced by retrying writing to the first magnetoresistive element 120.

### <2. Second Embodiment>

### <2-1. Configuration Example of Memory System>

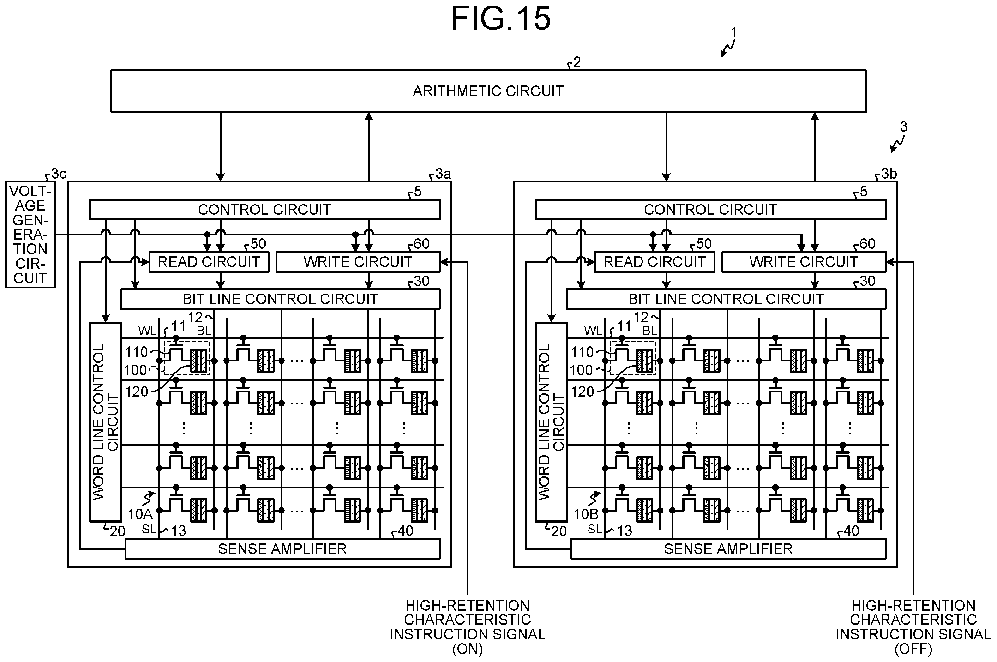

A configuration example of a memory system 1 according to a second embodiment will be described with reference to FIG. 15. FIG. 15 is a diagram illustrating the configuration example of the memory system 1 according to the second embodiment. The second embodiment is basically the same as the first embodiment, but its difference (write circuit 60) will be described.

As illustrated in FIG. 15, in the memory system 1 according to the second embodiment, a write circuit 60 of the storage circuit 3a and the write circuit 60 of the storage circuit 3b have the same configuration. More specifically, the memory system 1 according to the first embodiment includes the high-retention element write circuit 60A in the storage circuit 3a, and the low-retention element write circuit 60B in the storage circuit 3b, and separates a write flow to the high-retention element and a write flow to the low-retention element. However, the memory system 1 according to the second embodiment includes the write circuit 60 having the same configuration in the storage circuit 3a and the storage circuit 3b, and switches the write flow by an external signal.

For example, the write circuit 60 switches whether or not to execute verify processing in response to a high-retention characteristic instruction signal (ON/OFF) input from the control circuit 5. The high-retention characteristic instruction signal is a signal that instructs whether or not to execute verify processing. For example, when the high-retention characteristic instruction signal is in an ON state, it indicates that verify processing is executed, and when the high-retention characteristic instruction signal is in an OFF state, it indicates that verify processing is not executed. The high-retention characteristic instruction signal corresponds to an instruction signal instructing execution of verify processing which is an example of rewriting processing. Note that the instruction signal that instructs whether or not to execute verify processing is not limited to the high-retention characteristic instruction signal.

### <2-2. Write Processing>

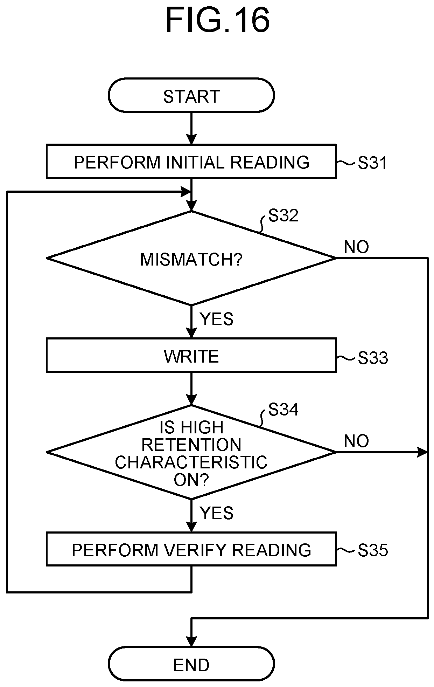

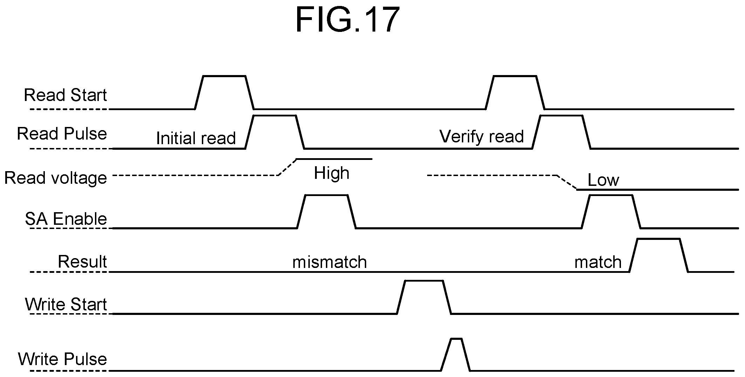

The write processing according to the second embodiment will be described with reference to FIGS. 16 and 17.

FIG. 16 is a flowchart illustrating an example of a flow of write processing to the high-retention element according to the second embodiment. In the example of FIG. 16, writing is executed at the same voltage based on the high-retention element writing method or the low-retention element writing method. The flow of the write processing is the same between the writing to the high-retention element in the storage circuit 3a and the writing to the low-retention element in the storage circuit 3b.

As illustrated in FIG. 16, in step S31, the read circuit 50 performs initial reading. After the initial reading, in step S32, the control circuit 5 determines whether or not the read data and the write data are mismatched, and when it is determined that those pieces of data are not mismatched (matched) (No in step S32), the processing ends. On the other hand, when the control circuit 5 determines that those pieces of data are mismatched (Yes in step S32), the write circuit 60 performs writing in step S33. After the writing, in step S34, the control circuit 5 determines whether or not the high-retention characteristic signal is on, and when it is determined that the high-retention characteristic signal is on (Yes in step S34), the read circuit 50 performs verify reading in step S35, and the processing returns to step S32. Thereafter, step S32 and subsequent processing is repeated. For example, when the read data and the write data are matched, the processing ends, and when the read data and the write data are mismatched, the writing is repeated. On the other hand, when it is determined that the high-retention characteristic signal is not on (No in step S34), the processing ends.

In such write processing, after the initial reading, when the read data and the write data are matched, the processing ends, and when the read data and the write data are not matched, writing is performed. In the case of writing to the high-retention element, the verify processing is performed, but in the case of writing to the low-retention element, the verify processing is not performed, and the processing ends.

FIG. 17 is a timing chart illustrating a timing of writing to the high-retention element or the low-retention element according to the second embodiment. In the example of FIG. 17, an example of writing from high resistance to low resistance is indicated.

As illustrated in FIG. 17, in the storage circuit 3a or the storage circuit 3b, the read circuit 50 issues a read pulse (Read Pulse: Initial read) in response to a read start signal (Read Start) from the control circuit 5. Since a read potential (Read voltage) changes according to the recording state, the read potential is detected by the sense amplifier 40 at the time point when the potential is determined. When the read data and the write data are not matched by comparison (Result: mismatch), the write circuit 60 issues a write pulse (Write Pulse) in response to a write start signal (Write Start) from the control circuit 5. When the write pulse ends, the read circuit 50 issues a read pulse (Read Pulse: Verify read) in response to the read start signal (Write Start) from the control circuit 5 based on ON/OFF of the high-retention characteristic signal for verification. When the read data and the write data are matched by comparison (Result: match), the processing ends.

In the example of FIG. 17, the pulse widths of the write pulses are the same in the storage circuit 3a or the storage circuit 3b. In the storage circuit 3b, since a low-retention element writing method is used for writing, it is desirable to apply a write pulse having a short pulse width. Therefore, in the example of FIG. 17, a write pulse having a shorter pulse width than the example of FIG. 12 is illustrated.

Although the timing chart for writing to the low-retention element according to the second embodiment is similar to that of the first embodiment, writing may be performed with pulses having different pulse widths in writing to the high-retention element and writing to the low-retention element as in the first embodiment by using a switching signal for switching the pulse width of the write pulse for the low-retention element and the pulse width of the write pulse for the high-retention element. That is, the pulse width of the voltage applied to the high-retention element or the low-retention element may be changed in response to the instruction signal instructing the change of the pulse width of the voltage.

### <2-3. Action and Effect>

As described above, according to the second embodiment, the effect according to the first embodiment can be obtained. That is, according to the second embodiment, it is possible to realize low power consumption writing, reduction in circuit scale, and reduction in a writing rate of the high-retention element.

In a case where the magnetic direction of the first magnetoresistive element 120 is not a desired state after applying a voltage to the first magnetoresistive element 120 by the first writing method, the write unit (for example, the write circuit 60) may apply a voltage to the first magnetoresistive element 120 again by the first writing method, in response to the instruction signal (for example, the high-retention characteristic instruction signal) instructing rewriting to the first magnetoresistive element 120. Thus, a write error rate of the first magnetoresistive element 120 can be reduced by retrying writing to the first magnetoresistive element 120.

In addition, the write unit may change the pulse width of the voltage to be applied to the first magnetoresistive element 120 or the second magnetoresistive element 120, in response to the instruction signal instructing the change of the pulse width of the voltage. As a result, since the pulse width can be adjusted, it is possible to suppress a delay related to writing while realizing low power consumption writing.

### <3. Third Embodiment>

### <3-1. Configuration Example of Memory System>

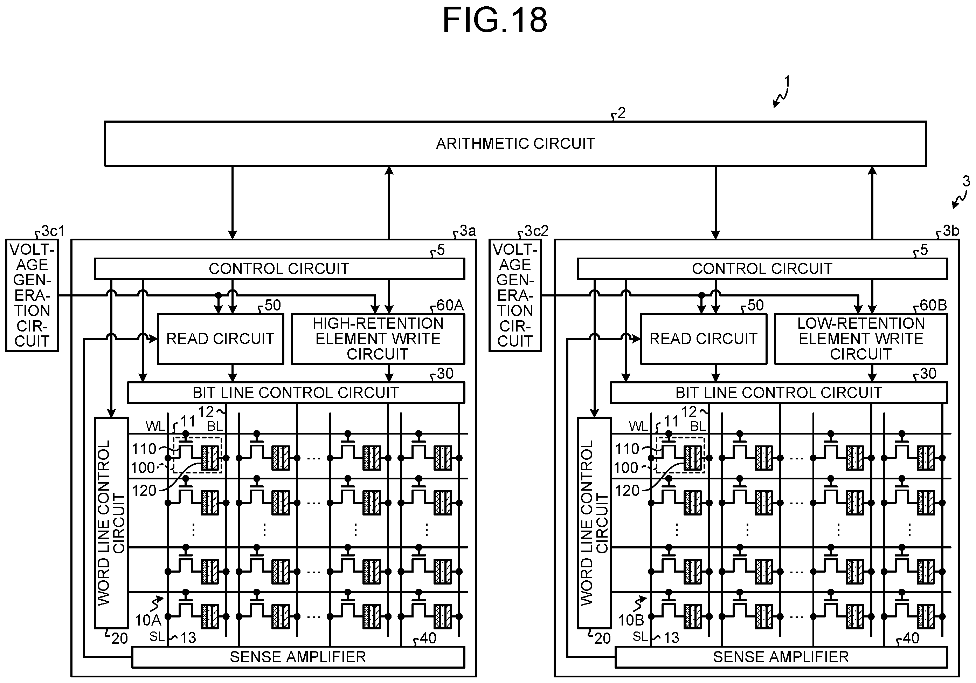

A configuration example of a memory system 1 according to a third embodiment will be described with reference to FIG. 18. FIG. 18 is a diagram illustrating the configuration example of the memory system 1 according to the third embodiment. The third embodiment is basically the same as the first embodiment, but its difference (two voltage generation circuits 3c1 and 3c2) will be described.

As illustrated in FIG. 18, the memory system 1 according to the third embodiment includes two voltage generation circuits 3c1 and 3c2. More specifically, the memory system 1 according to the first embodiment includes one voltage generation circuit 3c common to the storage circuit 3a and the storage circuit 3b, but the memory system 1 according to the second embodiment includes voltage generation circuits 3c1 and 3c2 for each of the storage circuit 3a and the storage circuit 3b. Note that the high-retention element write circuit 60A and the low-retention element write circuit 60B use different voltages from each other.

Here, in the first embodiment and the second embodiment, the write voltage to the high-retention element and the write voltage to the low-retention element are the same, but in the third embodiment, the write voltage to the high-retention element and the write voltage to the low-retention element are different. Even in this case, by using the high-retention element writing method, it is possible to reduce the write voltage (V₀ < V < V₁: see FIG. 6) to the high-retention element without making the voltages the same, and it is possible to realize low power consumption.

### <3-2. Write Processing>

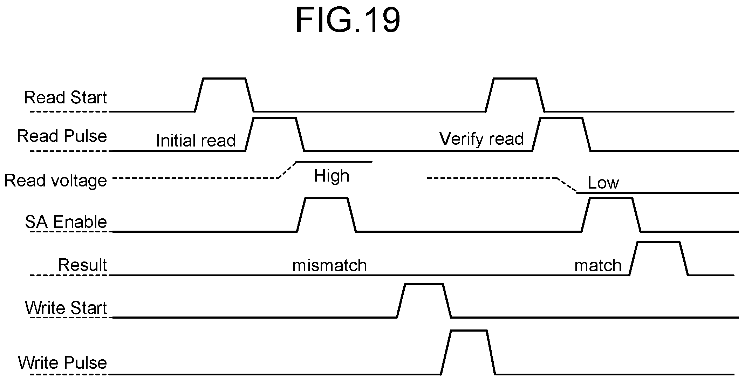

The write processing according to the third embodiment will be described with reference to FIG. 19. FIG. 19 is a timing chart illustrating a timing of writing to the high-retention element according to the third embodiment. In the example of FIG. 19, an example of writing from high resistance to low resistance is indicated.

In the third embodiment, the flowchart for writing to the high-retention element is similar to that of the first embodiment (see FIG. 11), the flowchart for writing to the low-retention element is similar to that of the first embodiment (see FIG. 13), and the timing chart for writing to the low-retention element is similar to that of the first embodiment (see FIG. 14). However, the timing chart for writing to the high-retention element according to the third embodiment is different from that of the first embodiment (see FIG. 12).

As illustrated in FIG. 19, the timing chart for writing to the high-retention element according to the third embodiment is different from that of the first embodiment only in the voltage of "Write Pulse". That is, an amplitude of the pulse of "Write Pulse" is different from that of the first embodiment, and the amplitude of the pulse according to the third embodiment is larger than the amplitude of the pulse according to the first embodiment. Note that the timing chart for writing to the high-retention element illustrated in FIG. 19 is the same as the timing chart for writing to the high-retention element illustrated in FIG. 12 except for the amplitude of the pulse of "Write Pulse", and thus description thereof is omitted.

As described above, in a case where both the high-retention element and the low-retention element are mounted, it is possible to reduce the write voltage to the high-retention element by applying different writing methods to these elements, and thus, it is possible to realize low power consumption writing. In addition, by retrying writing to the high-retention element, a write error rate to the high-retention element can be reduced.

### <3-3. Action and Effect>

As described above, according to the third embodiment, it is possible to obtain an effect other than the effect of reducing the circuit scale according to the first embodiment. That is, according to the third embodiment, it is possible to realize low power consumption writing and a decrease in a writing rate of the high-retention element.

The write unit may include a first voltage generation circuit 3c1 that generates a first voltage, a second voltage generation circuit 3c2 that generates a second voltage, a first write circuit (for example, high-retention element write circuit 60A) that applies the first voltage generated by the first voltage generation circuit 3c1 to the first magnetoresistive element 120 by a first writing method, and a second write circuit (for example, low-retention element write circuit 60B) that applies the second voltage generated by the second voltage generation circuit 3c2 to the second magnetoresistive element 120 by a second writing method. Even when such first voltage and second voltage are used, low power consumption writing can be realized.

### <4. Fourth Embodiment>

### <4-1. Configuration Example of Memory System>

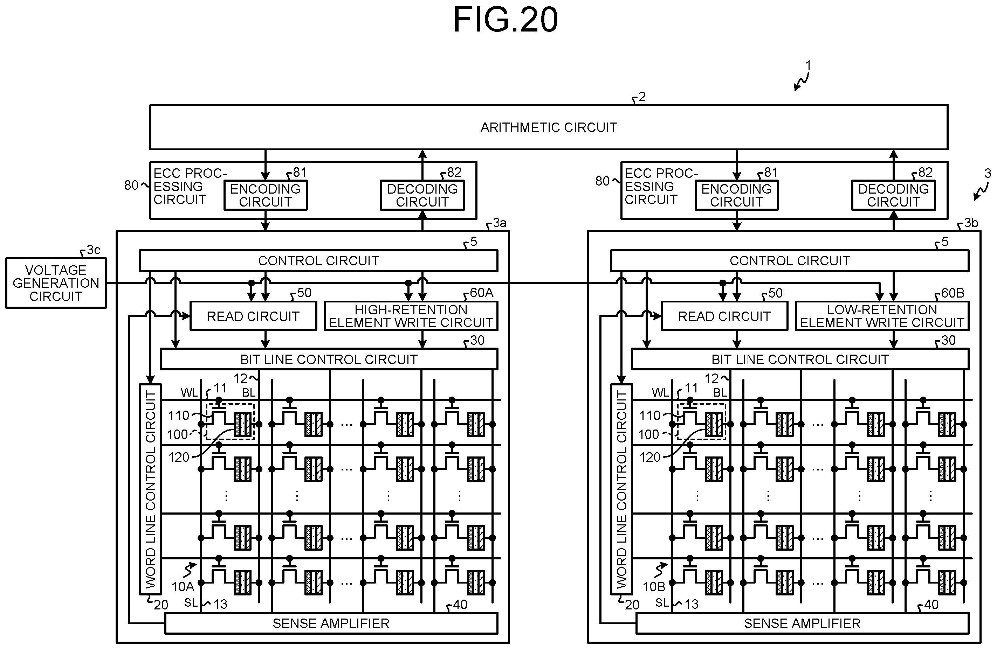

A configuration example of a memory system 1 according to a fourth embodiment will be described with reference to FIG. 20. FIG. 20 is a diagram illustrating the configuration example of the memory system 1 according to the fourth embodiment. The fourth embodiment is basically the same as the first embodiment, but its difference (two ECC processing circuits 80) will be described.

As illustrated in FIG. 20, the memory system 1 according to the fourth embodiment includes an ECC (Error-correcting code, Error checking and correction, and Error check and correct) processing circuit 80 for each of the storage circuit 3a and the storage circuit 3b. The ECC processing circuit 80 is provided between the arithmetic circuit 2 and the storage circuit 3a and between the arithmetic circuit 2 and the storage circuit 3b, respectively. The ECC processing circuit 80 is an error correction processing circuit that detects and corrects an error in information.

Note that the ECC processing circuit 80 includes an encoding circuit 81 and a decoding circuit 82. The encoding circuit 81 converts information into digital data for digital processing, transmission, recording, and the like. The decoding circuit 82 returns the converted data to the original information. The converted data is referred to as a code. Returning from the code to the original information is called decoding.

The memory system 1 having such a configuration has an ECC function (error correction function) for write/read data to/from the storage circuit 3a and the storage circuit 3b. As a result, it is possible to correct an error of data such as inversion at the time of writing to the storage circuit 3a and the storage circuit 3b or during retaining, and improve reliability (for example, reliability of arithmetic function) of data.

### <4-2. Action and Effect>

As described above, according to the fourth embodiment, the effect according to the first embodiment can be obtained. Furthermore, by providing the ECC processing circuit 80 for each of the storage circuit 3a and the storage circuit 3b, reliability of data can be improved.

### <5. Fifth Embodiment>

### <5-1. Configuration Example of Memory System>

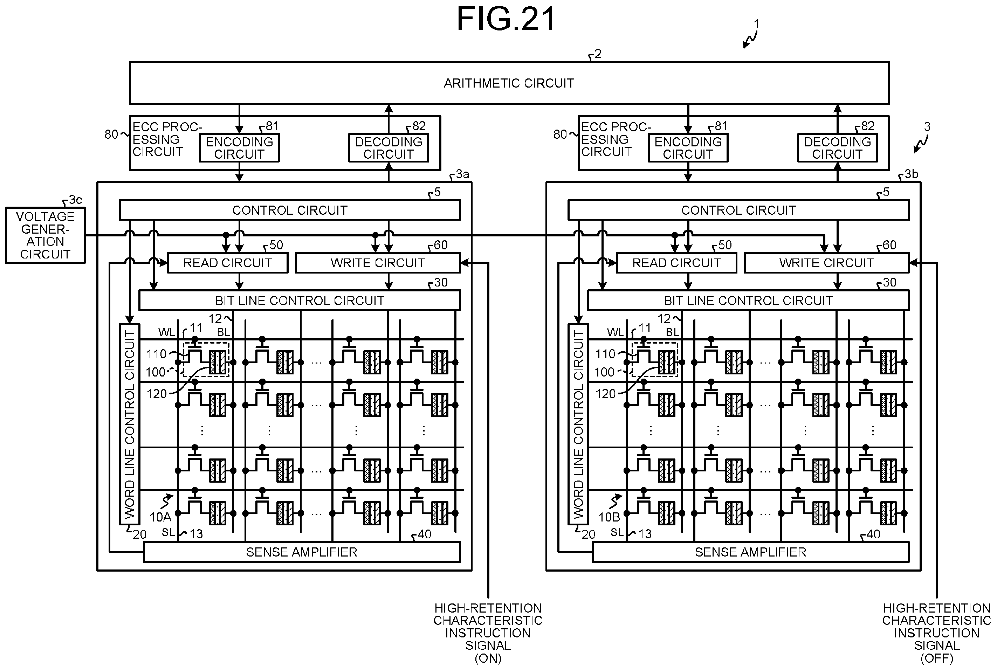

A configuration example of a memory system 1 according to a fifth embodiment will be described with reference to FIG. 21. FIG. 21 is a diagram illustrating the configuration example of the memory system 1 according to the fifth embodiment. The fifth embodiment is basically the same as the second embodiment, but its difference (two ECC processing circuits 80) will be described.

As illustrated in FIG. 21, the memory system 1 according to the fifth embodiment includes an ECC processing circuit 80 for each of the storage circuit 3a and the storage circuit 3b. The ECC processing circuit 80 is provided between the arithmetic circuit 2 and the storage circuit 3a and between the arithmetic circuit 2 and the storage circuit 3b, respectively. The ECC processing circuit 80 is the same as that of the fourth embodiment. Since the memory system 1 having such a configuration has an ECC function for write/read data to/from the storage circuit 3a and the storage circuit 3b, it is possible to correct an error of data such as inversion at the time of writing to the storage circuit 3a and the storage circuit 3b or during retaining, and improve reliability of data.

### <5-2. Action and Effect>

As described above, according to the fifth embodiment, the effect according to the second embodiment can be obtained. Furthermore, by providing the ECC processing circuit 80 for each of the storage circuit 3a and the storage circuit 3b, reliability of data can be improved.

### <6. Sixth Embodiment>

### <6-1. Configuration Example of Memory System>

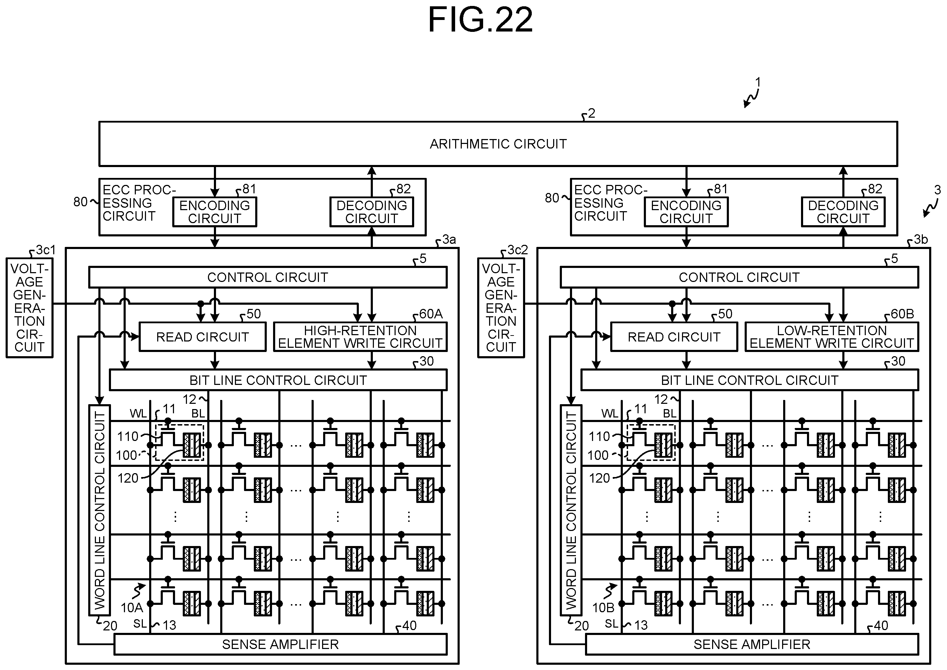

A configuration example of a memory system 1 according to a sixth embodiment will be described with reference to FIG. 22. FIG. 22 is a diagram illustrating the configuration example of the memory system 1 according to the sixth embodiment. The sixth embodiment is basically the same as the third embodiment, but its difference (two ECC processing circuits 80) will be described.

As illustrated in FIG. 22, the memory system 1 according to the sixth embodiment includes an ECC processing circuit 80 for each of the storage circuit 3a and the storage circuit 3b. The ECC processing circuit 80 is provided between the arithmetic circuit 2 and the storage circuit 3a and between the arithmetic circuit 2 and the storage circuit 3b, respectively. The ECC processing circuit 80 is the same as that of the fourth embodiment. Since the memory system 1 having such a configuration has an ECC function for write/read data to/from the storage circuit 3a and the storage circuit 3b, it is possible to correct an error of data such as inversion at the time of writing to the storage circuit 3a and the storage circuit 3b or during retaining, and improve reliability of data.

### <6-2. Action and Effect>

As described above, according to the sixth embodiment, the effect according to the third embodiment can be obtained. Furthermore, by providing the ECC processing circuit 80 for each of the storage circuit 3a and the storage circuit 3b, reliability of data can be improved.

### <7. Seventh Embodiment>

### <7-1. Configuration Example of Memory System>

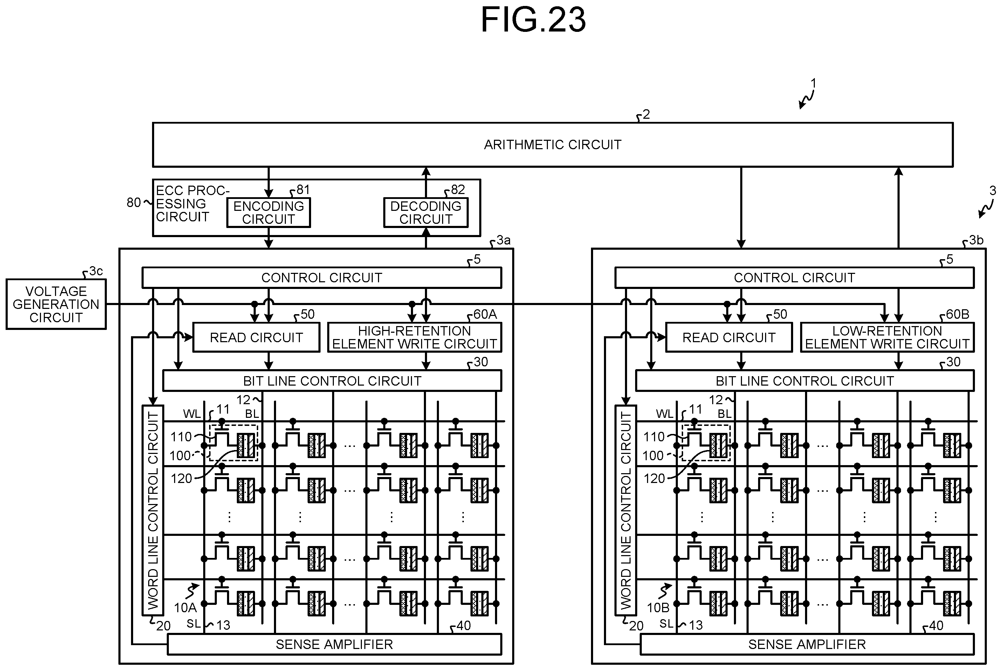

A configuration example of a memory system 1 according to a seventh embodiment will be described with reference to FIG. 23. FIG. 23 is a diagram illustrating the configuration example of the memory system 1 according to the seventh embodiment. The seventh embodiment is basically the same as the first embodiment, but its difference (one ECC processing circuit 80) will be described.

As illustrated in FIG. 23, the memory system 1 according to the seventh embodiment includes an ECC processing circuit 80 for the storage circuit 3a. The ECC processing circuit 80 is provided between the arithmetic circuit 2 and the storage circuit 3a. The ECC processing circuit 80 is the same as that of the fourth embodiment. Since the memory system 1 having such a configuration has an ECC function for write/read data to/from the storage circuit 3a, it is possible to correct an error of data such as inversion at the time of writing to the storage circuit 3a or during retaining, and improve reliability of data.

Here, in the seventh embodiment, only the storage circuit 3a including the high-retention element has an error correction function, and the storage circuit 3b including the low-retention element does not have an error correction function. For example, since the data during a recognition operation stored in the storage circuit 3b is data for which writing or reading with a low delay is desirable, the error correction function may be omitted.

### <7-2. Action and Effect>

As described above, according to the seventh embodiment, the effect according to the first embodiment can be obtained. Furthermore, by providing the ECC processing circuit 80 for the storage circuit 3a, reliability of data can be improved. In addition, it is possible to realize low-delay writing and reading as compared with a case where the ECC processing circuit 80 is provided for each of the storage circuit 3a and the storage circuit 3b.

### <8. Eighth Embodiment>

### <8-1. Configuration Example of Memory System>

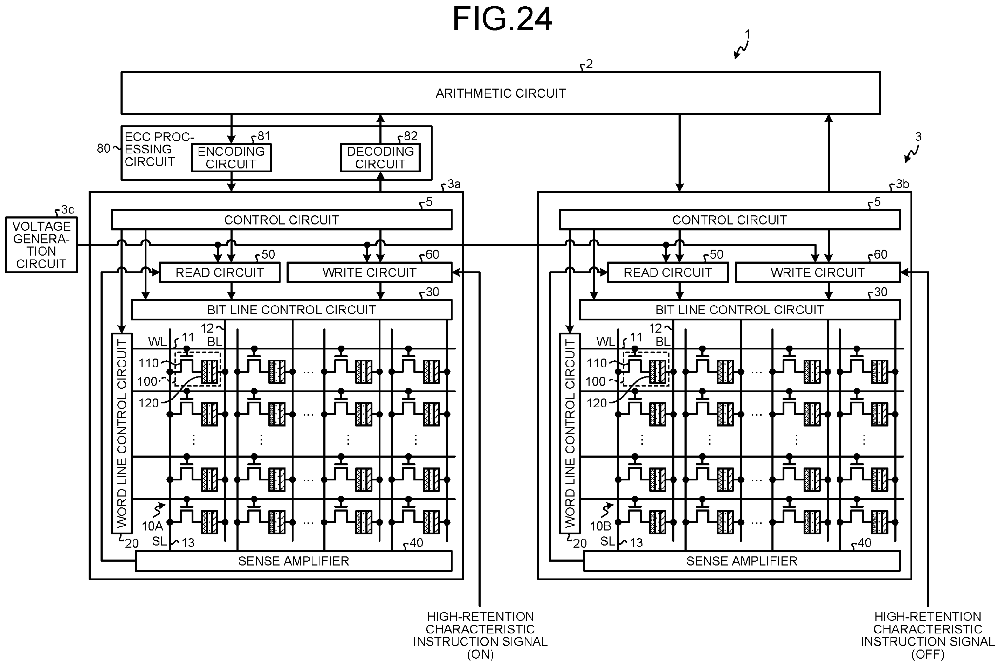

A configuration example of a memory system 1 according to an eighth embodiment will be described with reference to FIG. 24. FIG. 24 is a diagram illustrating the configuration example of the memory system 1 according to the eighth embodiment. The eighth embodiment is basically the same as the second embodiment, but its difference (one ECC processing circuit 80) will be described.

As illustrated in FIG. 24, the memory system 1 according to the eighth embodiment includes an ECC processing circuit 80 for the storage circuit 3a. The ECC processing circuit 80 is provided between the arithmetic circuit 2 and the storage circuit 3a. The ECC processing circuit 80 is the same as that of the fourth embodiment. Since the memory system 1 having such a configuration has an ECC function for write/read data to/from the storage circuit 3a, it is possible to correct an error of data such as inversion at the time of writing to the storage circuit 3a or during retaining, and improve reliability of data.

Here, in the eighth embodiment, similarly to the seventh embodiment, only the storage circuit 3a including the high-retention element has an error correction function, and the storage circuit 3b including the low-retention element does not have an error correction function. Since the data during a recognition operation stored in the storage circuit 3b is data for which writing or reading with a low delay is desirable, the error correction function may be omitted.

### <8-2. Action and Effect>

As described above, according to the eighth embodiment, the effect according to the second embodiment can be obtained. Furthermore, by providing the ECC processing circuit 80 for the storage circuit 3a, reliability of data can be improved. In addition, it is possible to realize low-delay writing and reading as compared with a case where the ECC processing circuit 80 is provided for each of the storage circuit 3a and the storage circuit 3b.

### <9. Ninth Embodiment>

### <9-1. Configuration Example of Memory System>

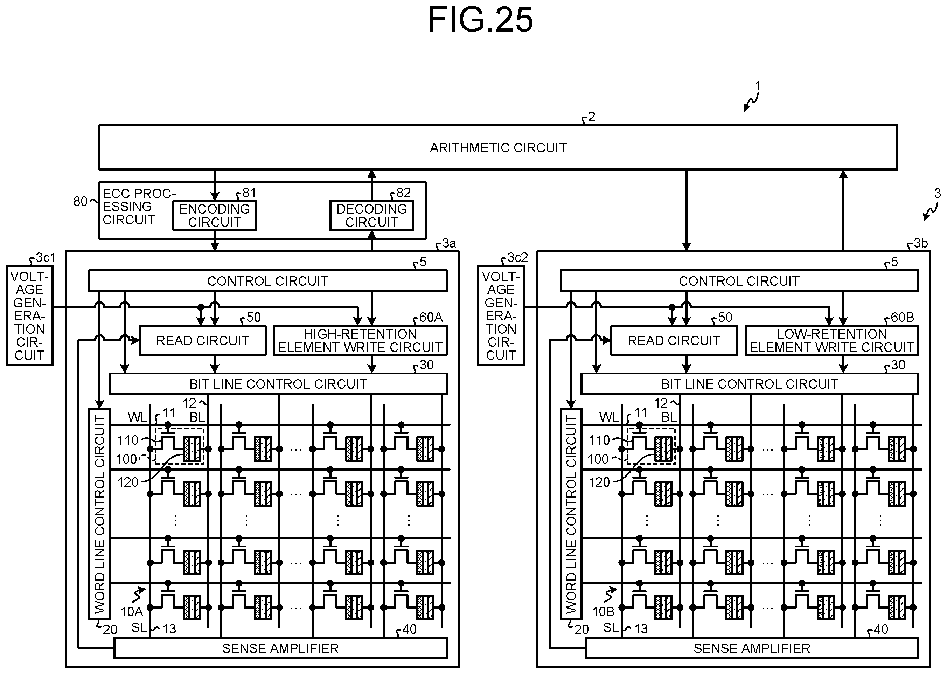

A configuration example of a memory system 1 according to a ninth embodiment will be described with reference to FIG. 25. FIG. 25 is a diagram illustrating the configuration example of the memory system 1 according to the ninth embodiment. The ninth embodiment is basically the same as the third embodiment, but its difference (one ECC processing circuit 80) will be described.

As illustrated in FIG. 25, the memory system 1 according to the ninth embodiment includes an ECC processing circuit 80 for the storage circuit 3a. The ECC processing circuit 80 is provided between the arithmetic circuit 2 and the storage circuit 3a. The ECC processing circuit 80 is the same as that of the fourth embodiment. Since the memory system 1 having such a configuration has an ECC function for write/read data to/from the storage circuit 3a, it is possible to correct an error of data such as inversion at the time of writing to the storage circuit 3a or during retaining, and improve reliability of data.

Here, in the ninth embodiment, similarly to the seventh embodiment and the eighth embodiment, only the storage circuit 3a including the high-retention element has an error correction function, and the storage circuit 3b including the low-retention element does not have an error correction function. Since the data during a recognition operation stored in the storage circuit 3b is data for which writing or reading with a low delay is desirable, the error correction function may be omitted.

### <9-2. Action and Effect>

As described above, according to the ninth embodiment, the effect according to the third embodiment can be obtained. Furthermore, by providing the ECC processing circuit 80 for the storage circuit 3a, reliability of data can be improved. In addition, it is possible to realize low-delay writing and reading as compared with a case where the ECC processing circuit 80 is provided for each of the storage circuit 3a and the storage circuit 3b.

### <10. Other Embodiments>

The configurations, processing, and the like according to the above-described embodiments (examples and modifications) may be implemented in various different modes other than the above-described embodiments. For example, the configurations, the processing, and the like are not limited to the above-described examples, and may be various modes. Furthermore, for example, the configurations, the processing procedures, the specific names, and the information including various types of data and parameters illustrated in the document or the drawings can be arbitrarily changed unless otherwise specified.

In addition, the configurations, the processing, and the like according to the above-described embodiments (examples and modifications) are not necessarily physically configured as illustrated in the drawings. That is, a specific form of distribution and integration of each apparatus is not limited to the illustrated form, and all or a part thereof can be functionally or physically distributed and integrated in an arbitrary unit according to various types of loads, usage status, and the like.

Furthermore, the configurations, processing, and the like according to the above-described embodiments (examples and modifications) may be appropriately combined. Furthermore, the effects described in the present specification are merely examples and are not limited, and other effects may be provided.

As the above-described low-retention element writing method, a writing method other than the method according to the above-described embodiments can be applied. For example, a writing method using a rectangular pulse or a writing method using a non-rectangular pulse described below can be applied. Also, as the high-retention element writing method, a writing method other than the method according to the above embodiments can be applied. For example, a writing method using a rectangular pulse or a writing method using a non-rectangular pulse described below can be applied. These writing methods and the method described in "Voltage-induced switching with long tolerance of voltage-pulse duration in a perpendicularly magnetized free layer, Rie Matsumoto, Applied Physics Express (2019)" can also be used in combination.

### <10-1. Writing Method Using Rectangular Pulse>

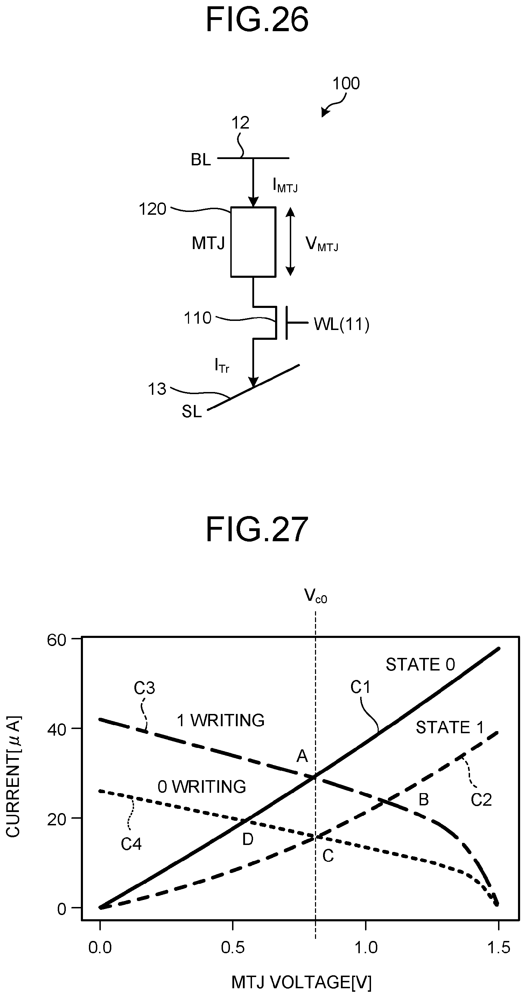

A writing method using a rectangular pulse according to the present embodiment will be described with reference to FIGS. 26 to 28.

FIG. 26 is a diagram schematically illustrating the memory cell 100. In the example of FIG. 26, the magnetoresistive element 120 is an MTJ (MTJ element), and the selection element 110 is an n-channel MOS transistor. As described above, by applying a voltage to the bit line 12 (BL), the source line 13 (SL), and the word line 11 (WL) connected to the memory cell 100, a current can flow in the memory cell 100.

Here, it is assumed that a bit line voltage of the bit line 12 (BL) is V_{BL}, a source line voltage of the source line 13 (SL) is V_{SL}, and a word line voltage of the word line 11 (WL) is V_{WL}. In addition, an MTJ voltage applied to the MTJ is referred to as V_{MTJ}. In order to perform writing by using the VCMA effect, it is necessary to set the magnetic anisotropy of the storage layer 124 to 0 by applying a voltage (write voltage) to the MTJ. The MTJ voltage V_{MTJ} when the magnetic anisotropy of the storage layer 124 becomes 0 is referred to as V_{c0}. Since the MTJ voltage V_{MTJ} depends on the bit line voltage V_{BL}, the source line voltage V_{SL}, and the word line voltage V_{WL}, it is necessary to adjust these voltages so that the MTJ voltage V_{MTJ} becomes V_{c0}.

FIG. 27 is a diagram plotting a relationship between the MTJ voltage V_{MTJ} and the current flowing through the memory cell 100. Here, a curve C1 represents the MTJ current in a state 0, and a curve C2 represents the MTJ current in a state 1. Since a resistance value in the state 0 is smaller than a resistance value of the state 1, the MTJ current in the state 0 is larger than the MTJ current in the state 1 at the same MTJ voltage. In addition, a curve C3 represents a transistor current when the state 1 is written, and a curve C4 represents a transistor current when the state 0 is written. Here, the source line voltage V_{SL} is grounded, the word line voltage V_{WL} is set to a different value when the state 0 is written and when the state 1 is written, and the bit line voltage V_{BL} is set to the same value when the state 0 is written and when the state 1 is written.

As can be seen from FIG. 26, since the MTJ current and the transistor current have the same value, the voltage V_{MTJ} applied to the MTJ by applying the voltage to the memory cell 100 is an intersection of the curves C1 to C4. Specifically, in a case where a state 1 is written in a state 0, a voltage indicated by an intersection A of the curve C1 and the curve C3 is applied to the MTJ. In a case where a state 1 is written in a state 1, a voltage indicated by an intersection B of the curve C2 and the curve C3 is applied to the MTJ. In a case where a state 0 is written in a state 1, a voltage indicated by an intersection C of the curve C2 and the curve C4 is applied to the MTJ. In a case where a state 0 is written in a state 0, a voltage indicated by an intersection D of the curve C1 and the curve C4 is applied to the MTJ. It is noted that the voltage at the intersections A and C matches the voltage V_{c0} at which the magnetic anisotropy of the storage layer 124 becomes 0. Conversely, the word line voltage V_{WL} is adjusted such that the voltage at the intersections A and C matches the voltage V_{c0}. Then, as can be seen from the fact that the curve C3 and the curve C4 are different, the adjusted voltage has different values when a state 0 is written and when a state 1 is written. By applying a voltage adjusted in this manner to the memory cell 100, it can be seen that the MTJ voltage V_{MTJ} becomes equal to V_{c0} and the magnetic anisotropy of the storage layer 124 becomes 0 in a case where a state 1 is written in a state 0 and a case where a state 0 is written in a state 1, so that writing is performed in the opposite state.

On the other hand, in the case where the state 1 is written in the state 1, the voltage at the intersection B becomes larger than V_{c0}, and the magnetic anisotropy of the storage layer 124 becomes negative. At this time, the magnetization of the storage layer 124 cannot perform a desired precession motion, and remains in the state 1 after the pulse voltage application. That is, unlike the toggle type writing, the state is not erroneously changed to the state 0. In addition, in the case where the state 0 is written in the state 0, the voltage at the intersection D becomes smaller than V_{c0}, and the magnetic anisotropy of the storage layer 124 remains positive. At this time, magnetization of the storage layer 124 does not perform a precession motion, and remains in the state 0 after the pulse voltage application. That is, unlike the toggle type writing, the state is not erroneously changed to the state 1. As described above, it can be seen that the state 0 and the state 1 can be written in a non-toggle manner regardless of the initial state.

Here, since the anisotropy is 0 at each of the intersections A and C, precession writing is possible. When a magnetization state changes due to a precession motion, an operating point changes from A to B or from C to D. Since the intersection B is an in-plane magnetization film, writing is not possible due to a precession motion around a vertical axis. Since the intersection D is a perpendicular magnetization film, a precession motion does not occur and writing is not possible. Note that the writing is not limited to the precession motion, and may be, for example, a long pulse method.

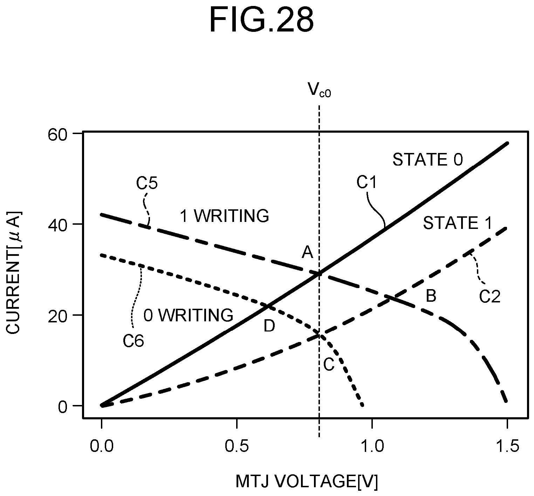

FIG. 28 is a diagram plotting the relationship between the MTJ voltage V_{MTJ} and the current flowing through the memory cell 100. Here, a curve C1 and a curve C2 are the same MTJ currents as those in FIG. 27. In addition, a curve C5 represents a transistor current when a state 1 is written, and a curve C6 represents a transistor current when a state 0 is written. Here, the source line voltage V_{SL} is grounded, the word line voltage V_{WL} is set to the same value when the state 0 is written and when the state 1 is written, and the bit line voltage V_{BL} is set to a different value when the state 0 is written and when the state 1 is written.

As can be seen from FIG. 26, since the MTJ current and the transistor current have the same value, the voltage V_{MTJ} applied to the MTJ by applying the voltage to the memory cell 100 is an intersection of the curve C1, the curve C2, the curve C5, and the curve C6. Specifically, in a case where a state 1 is written in a state 0, a voltage indicated by an intersection A of the curve C1 and the curve C5 is applied to the MTJ. In a case where a state 1 is written in a state 1, a voltage indicated by an intersection B of the curve C2 and the curve C5 is applied to the MTJ. In a case where a state 0 is written in a state 1, a voltage indicated by an intersection C of the curve C2 and the curve C6 is applied to the MTJ. In a case where a state 0 is written in a state 0, a voltage indicated by an intersection D of the curve C1 and the curve C6 is applied to the MTJ. The voltages from the intersection A to the intersection D are in the same relationship as in FIG. 27, and the bit line voltage V_{BL} is adjusted such that the voltages at the intersection A and the intersection C match the voltage V_{c0}. Then, as can be seen from the fact that the curve C5 and the curve C6 are different, the adjusted voltage has different values when a state 0 is written and when a state 1 is written. According to the same discussion as FIG. 27, as described above, the state 0 and the state 1 can be written in a non-toggle manner regardless of the initial state.

### <10-2. Simulation Results>

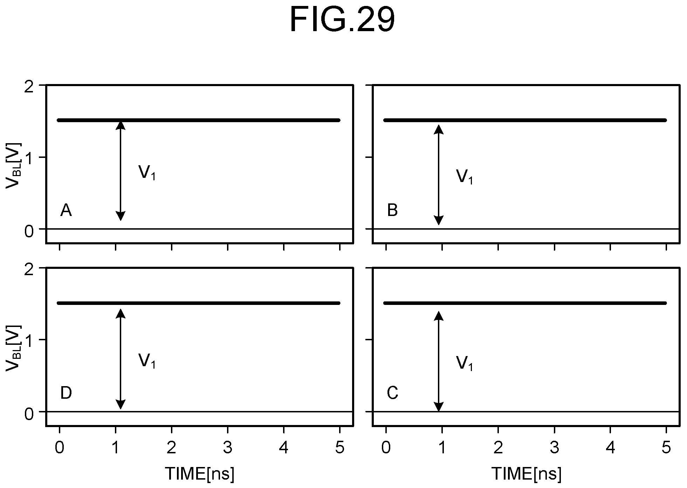

Simulation results according to the present embodiment will be described with reference to FIGS. 29 to 34.

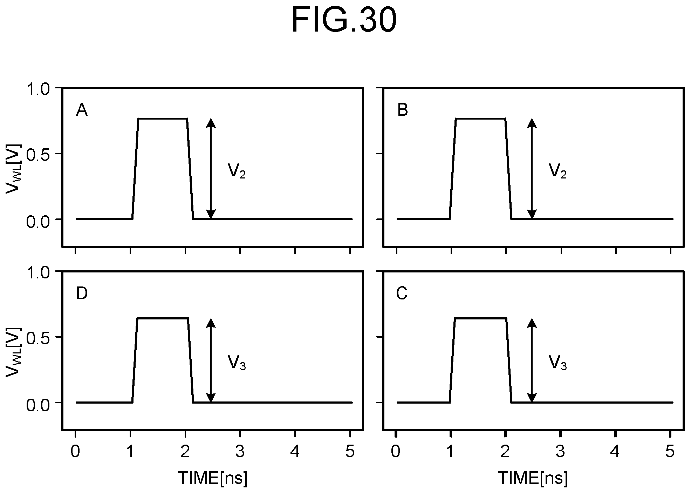

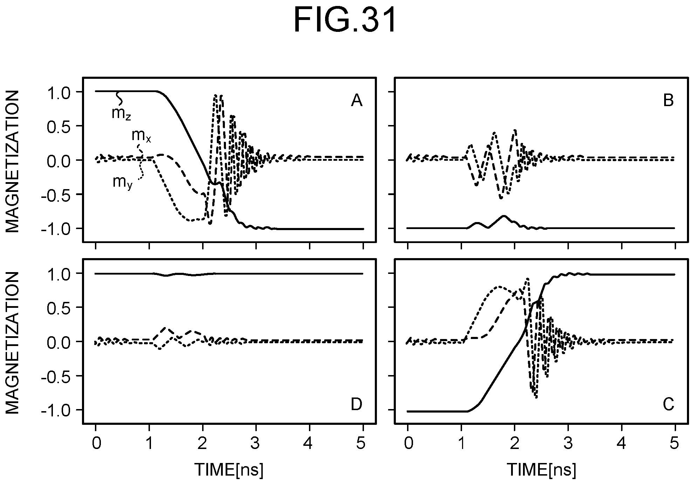

In FIGS. 29 to 31, similarly to FIG. 27, the source line voltage V_{SL} is grounded, FIG. 29 is a diagram illustrating that the bit line voltage V_{BL} has the same value when a state 0 is written and when a state 1 is written, FIG. 30 is a diagram illustrating that the word line voltage V_{WL} has different values when a state 0 is written and when a state 1 is written, and FIG. 31 is a diagram illustrating a simulation result of the magnetization motion under the conditions of FIGS. 29 and 30.

Each diagram arranged by a 2 × 2 grid in FIGS. 29 to 31 corresponds to the intersection A to the intersection D illustrated in FIG. 27, respectively. That is, an upper row corresponds to when a state 1 is written, a lower row corresponds to when a state 0 is written, a left column corresponds to when an initial state is a state 0, and a right column corresponds to when an initial state is a state 1. In addition, a horizontal axis in each drawing represents a time, a vertical axis represents each axis component of the bit line voltage V_{BL} in FIG. 29, the word line voltage V_{WL} in FIG. 30, and magnetization of the storage layer 124 in FIG. 31. In FIG. 29, a constant voltage of V1 is applied to the bit line voltage V_{BL} in common between the state 1 writing in the upper row and the state 0 writing in the lower row. In FIG. 30, the word line voltage V_{WL} is applied with a pulse of 1 ns with different voltages of V2 for the state 1 writing in the upper row, and V3 for the state 0 writing in the lower row.

The magnetization motion when such a voltage is applied is illustrated in FIG. 31. In a case where a state 1 is written when the initial state is a state 0, as indicated by A, a z component of the magnetization is +1 before the pulse voltage application, but is -1 after the pulse application, and it can be seen that a state change occurs. Similarly, in a case where a state 0 is written when the initial state is a state 1, as indicated by C, the z component of the magnetization is -1 before the pulse voltage application, but is +1 after the pulse application, and it can be seen that a state change occurs. On the other hand, in a case where the initial state and the writing state are the same, as indicated by B and D, it can be seen that the magnetization motion is observed during the pulse application, but the sign of the z component of the magnetization is not changed before and after the pulse voltage application, and the writing is not performed. As described above, it can be seen that the non-toggle type writing can be performed by applying different voltages for the writing of the state 0 and the writing of the state 1 regardless of the initial state.

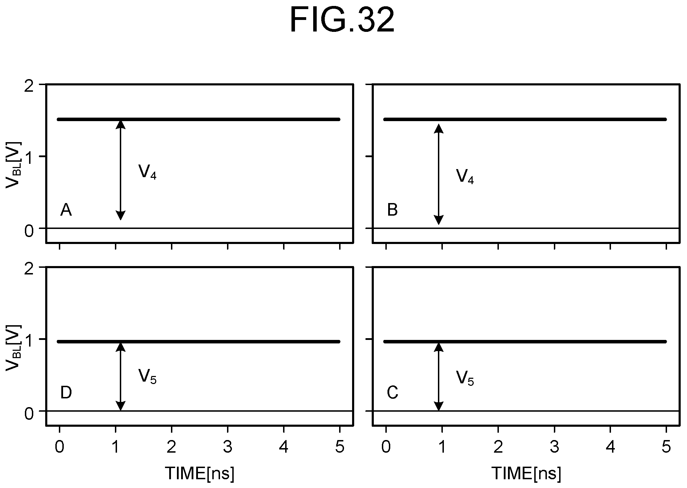

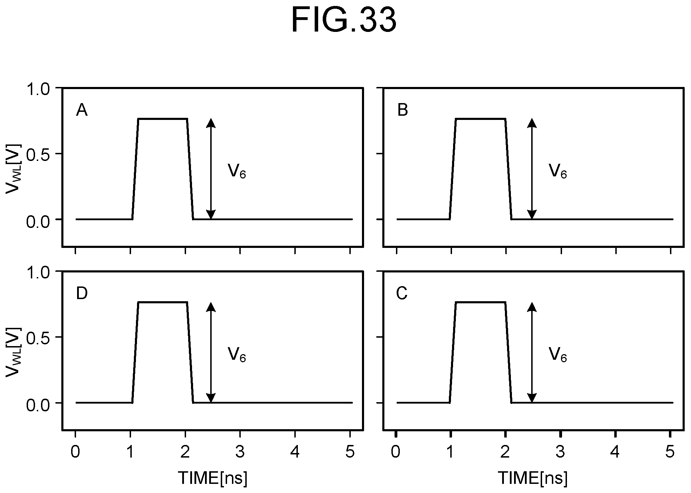

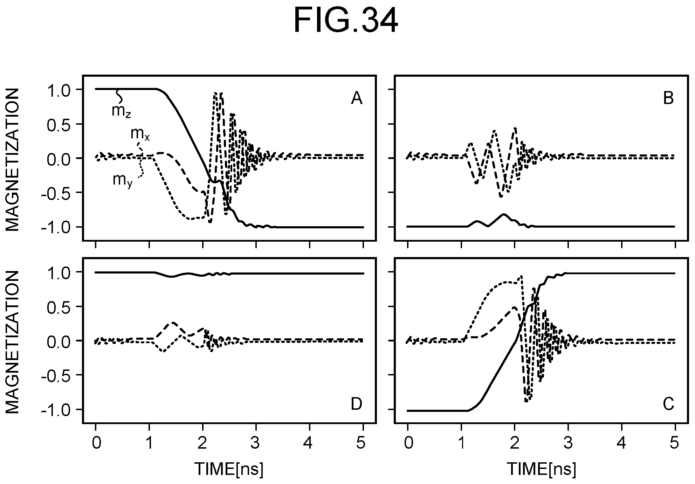

In FIGS. 32 to 34, similarly to FIG. 28, the source line voltage V_{SL} is grounded, FIG. 32 is a diagram illustrating that the bit line voltage V_{BL} has the different values when a state 0 is written and when a state 1 is written, FIG. 33 is a diagram illustrating that the word line voltage V_{WL} has the same value when a state 0 is written and when a state 1 is written, and FIG. 34 is a diagram illustrating a simulation result of the magnetization motion under the conditions of FIGS. 32 and 33.

Each diagram arranged by a 2 × 2 grid in FIGS. 32 to 34 corresponds to the intersection A to the intersection D illustrated in FIG. 28, respectively. That is, an upper row corresponds to when a state 1 is written, a lower row corresponds to when a state 0 is written, a left column corresponds to when an initial state is a state 0, and a right column corresponds to when an initial state is a state 1. In addition, a horizontal axis in each drawing represents a time, a vertical axis represents each axis component of the bit line voltage V_{BL} in FIG. 32, the word line voltage V_{WL} in FIG. 33, and the magnetization of the storage layer 124 in FIG. 34. In FIG. 32, the bit line voltage V_{BL} is applied at a constant voltage with different voltages of V4 for the state 1 writing in the upper row and V5 for the state 0 writing in the lower row are applied. In FIG. 33, the word line voltage V_{WL} is applied with a pulse of 1 ns with a voltage of V6, for the state 1 writing in the upper row and the state 0 writing in the lower row in common. The magnetization motion when such a voltage is applied is illustrated in FIG. 34. Although details are different, it is similar to the magnetization motion illustrated in FIG. 31, and the non-toggle type writing is performed by applying different voltages for the writing of the state 0 and the writing of the state 1 regardless of the initial state.

In FIGS. 29 to 34, the bit line voltage V_{BL} is a constant voltage and the word line voltage V_{WL} is a pulse voltage, but conversely, the bit line voltage V_{BL} may be a pulse voltage and the word line voltage V_{WL} may be a constant voltage. Further, both the bit line voltage V_{BL} and the word line voltage V_{WL} may be pulse voltages. At this time, the rise or fall of the pulse voltage may or may not match between the bit line voltage V_{BL} and the word line voltage V_{WL}. In addition, although the pulse width is 1 ns, this is merely an example, and any pulse width can be adopted as long as writing can be performed correctly.

### <10-3. Writing Method Using Non-Rectangular Pulse>

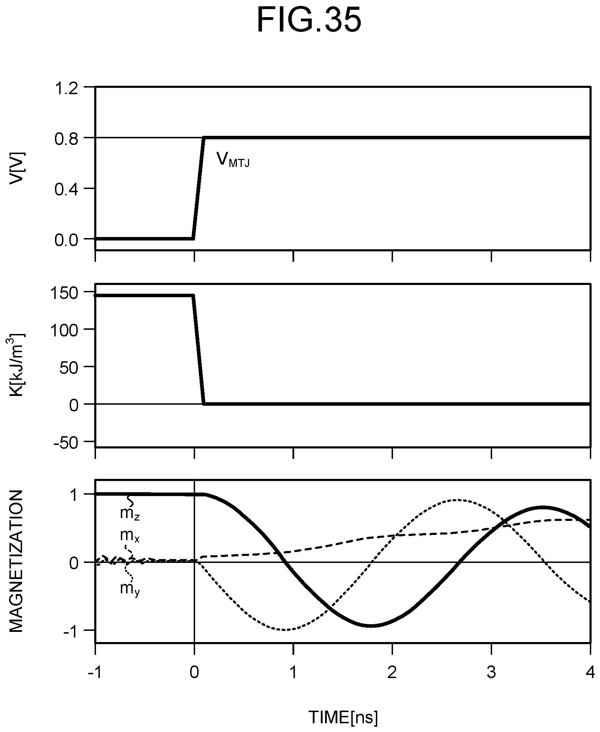

A writing method using a non-rectangular pulse according to the present embodiment will be described with reference to FIGS. 35 to 46.

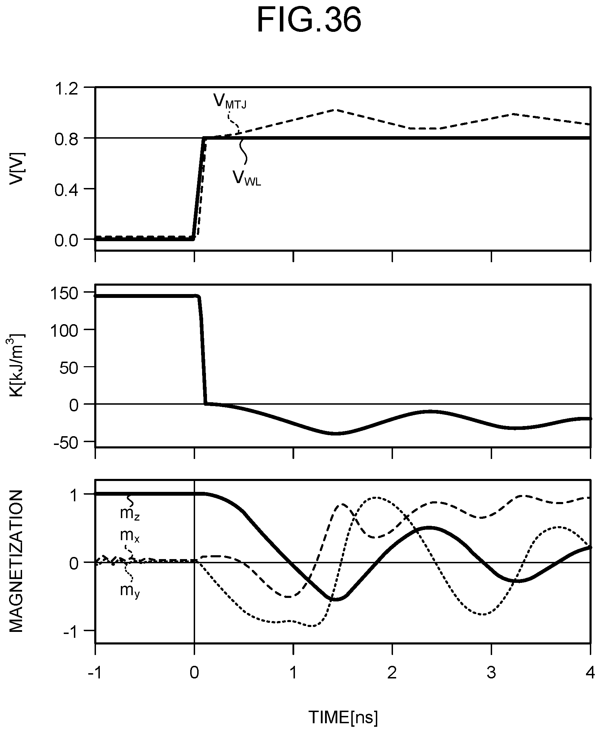

In the above description, as illustrated in FIG. 30, the shape of the write pulse is a rectangular pulse. The rectangle means that the voltage of the write pulse is substantially constant. The simulation results of the magnetization motion when the rectangular pulse is used are illustrated in FIGS. 35 and 36. For comparison, FIG. 35 illustrates a case of the MTJ alone, and FIG. 36 illustrates a case of the memory cell 100 of the present embodiment. An upper row indicates a voltage, a middle row indicates perpendicular magnetic anisotropy energy K, and a lower row indicates magnetization. In the MTJ of FIG. 35, a voltage V_{c0} is directly applied to the MTJ. In the memory cell 100 of FIG. 36, the word line voltage V_{WL} is adjusted so that the voltage V_{c0} is applied to the MTJ. In both cases, after a relaxation time of 1 ns, the above-described voltage is continuously applied from a time 0 ns.

In FIG. 35, since the MTJ voltage V_{MTJ} is fixed, K = 0 is maintained. As a result, the magnetization motion indicated in the lower row is a spiral ideal precession motion with a constant period. On the other hand, in the memory cell 100 of FIG. 36, although the word line voltage V_{WL} is fixed, the MTJ voltage V_{MTJ} is a value obtained by dividing the bit line voltage by the MTJ and the selection element 110, and is not constant.

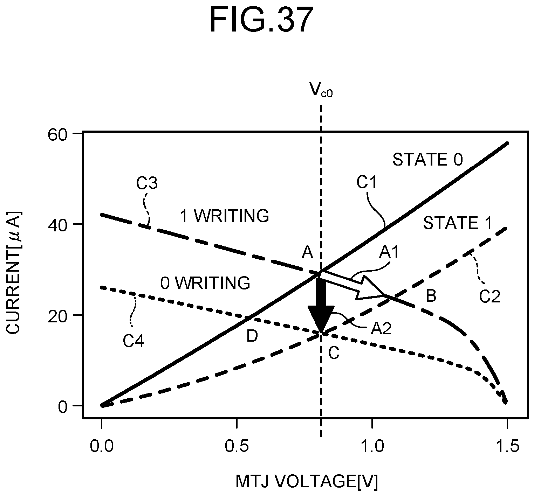

Specifically, as indicated by a broken line in the upper row of FIG. 36, the magnetization motion is interlocked. Since the magnetization is in the state 0 at the time 0 ns, V_{c0} is applied to the MTJ as expected. However, once the magnetization motion starts, the magnetization deviates from the state 0. A resistance value R of the MTJ depends on a perpendicular component of the magnetization of the storage layer 124. The intersection of the MTJ current determined by the resistance value and the transistor current becomes a new operating point. This state is indicated by an arrow A1 in FIG. 37. The MTJ current moves between the state 0 and the state 1 in accordance with the magnetization motion, and the operating point moves between A and B.

A time dependency of K is indicated in the middle row of FIG. 36. Although K = 0 at the start of voltage application, the MTJ voltage becomes larger than V_{c0} due to an increase in resistance. Since the perpendicular magnetic anisotropy is not constant at 0 but takes a negative value, the storage layer 124 becomes an in-plane magnetization layer. Since not only an external magnetic field but also an effective magnetic field that tends to collapse the magnetization in plane acts, the magnetization motion illustrated in the lower row of FIG. 36 is not an ideal spiral precession motion but is distorted. In the magnetization motion in the lower row of FIG. 35, the z component of the magnetization has a minimum value at about 1.9 ns. The absolute value thereof is 0.93. In the magnetization motion in the lower row of FIG. 36, the z component of the magnetization has a minimum value at about 1.4 ns. The absolute value thereof is 0.54. As the absolute value of the minimum value is closer to 1, writing can be stably performed when the voltage application is stopped at that time. For this reason, in the writing using the memory cell 100 as compared with the MTJ alone, the stability of the writing tends to decrease.

In order to eliminate such instability of writing, in the writing according to the present embodiment, the voltage pulse may have a non-rectangular shape. FIG. 37 illustrates a concept thereof. In the rectangular pulse, when the operating point moves from A to B, the MTJ voltage increases and the perpendicular magnetic anisotropy is not 0, which is a problem. The operating point is then moved from A to C. In this way, the MTJ voltage remains at V_{c0} even during the magnetization motion, and the perpendicular magnetic anisotropy is also maintained at 0.

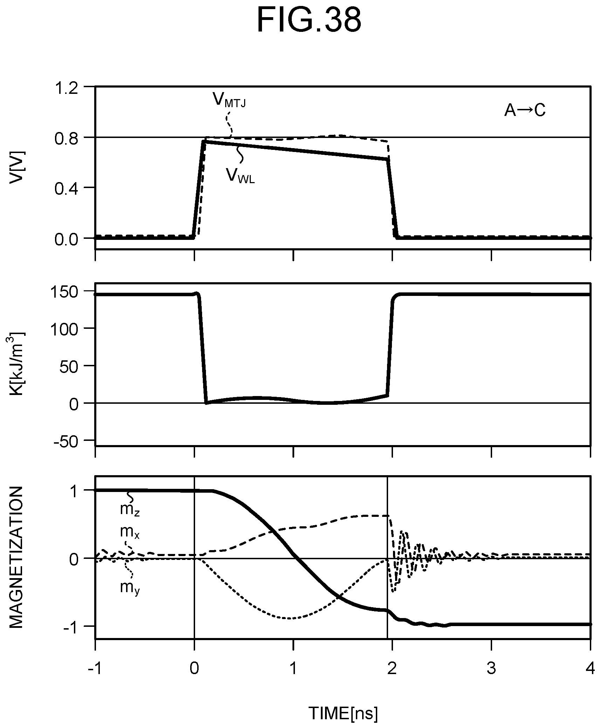

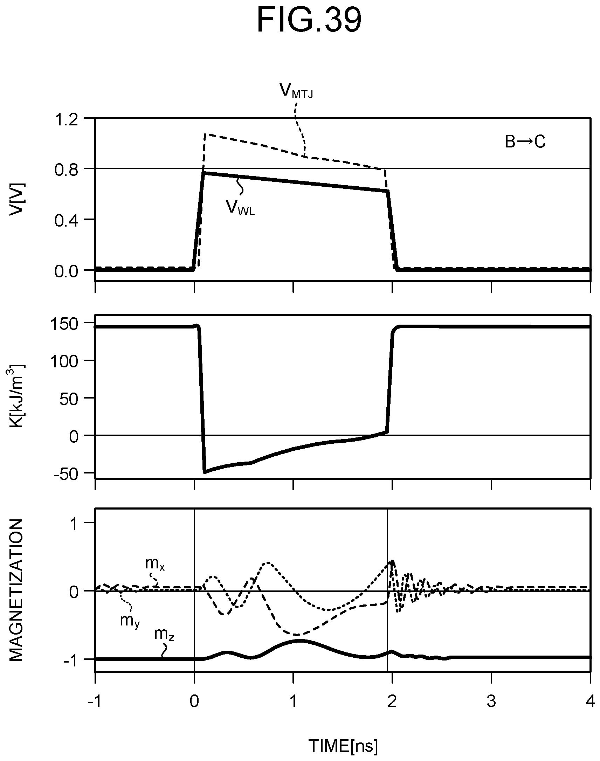

FIGS. 38 and 39 illustrate simulation results of the writing of the state 1. In FIG. 38, the initial state is a state 0, and in FIG. 39, the initial state is a state 1. The MTJ voltage in the upper row of FIG. 38 is substantially constant, and K in the middle row is substantially 0. The result is an ideal precession motion. In the lower row, the absolute value of the z component of the magnetization at 1.9 ns when the voltage pulse ends is 0.79. Since the value is 0.54 when the rectangular pulse is used, it can be seen that the stability of writing is improved. In addition, magnetization reversal does not occur in FIG. 39. That is, the non-toggle type writing can be realized as in the case of the rectangular pulse.

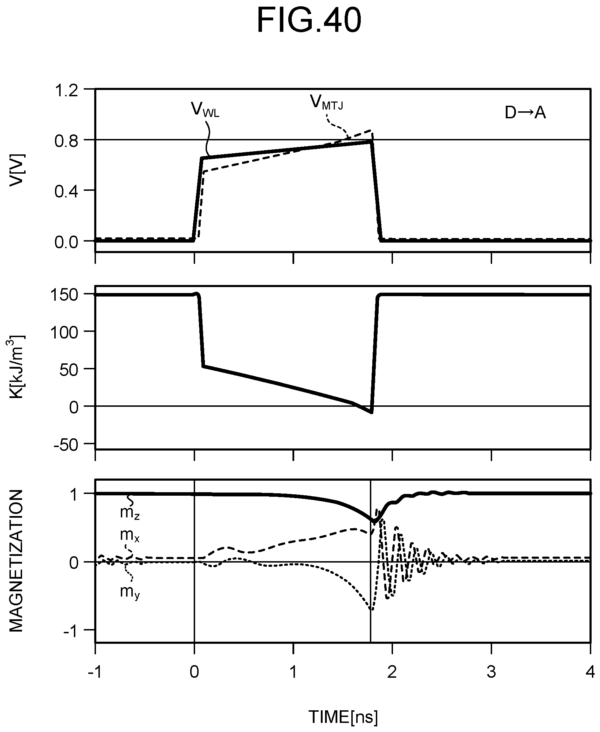

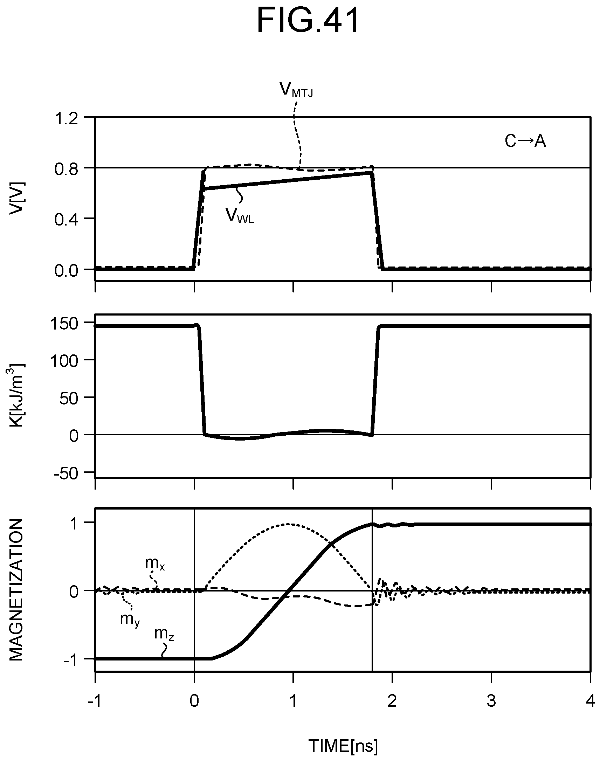

Similarly, the simulation results of the writing of the state 0 are illustrated in FIGS. 40 and 41. In FIG. 40, the initial state is a state 0, and in FIG. 41, the initial state is a state 1. The MTJ voltage in the upper row of FIG. 41 is substantially constant, and K in the middle row is substantially 0. The result is an ideal precession motion. In the lower row, the absolute value of the z component of the magnetization at 1.7 ns at which the voltage pulse ends is 0.99, and it can be seen that the stability of writing is improved. In addition, magnetization reversal does not occur in FIG. 40. That is, the non-toggle type writing can be realized as in the case of the rectangular pulse.

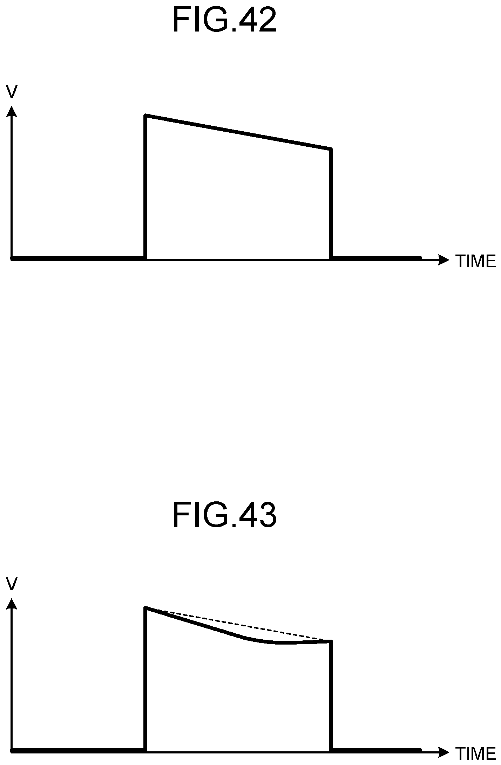

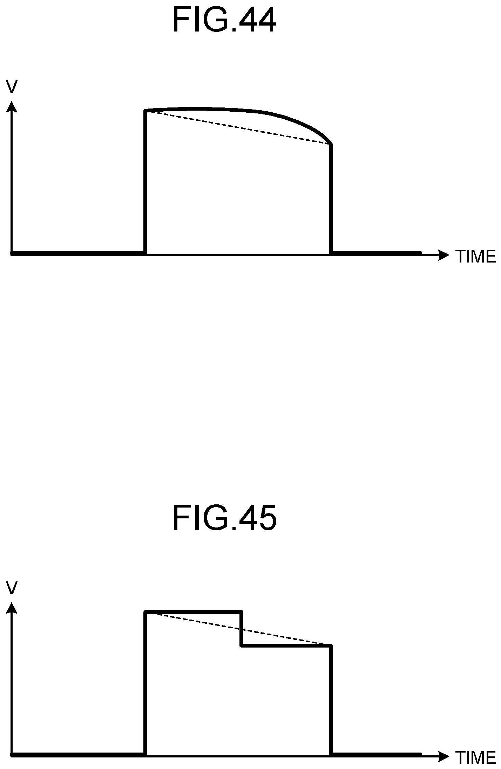

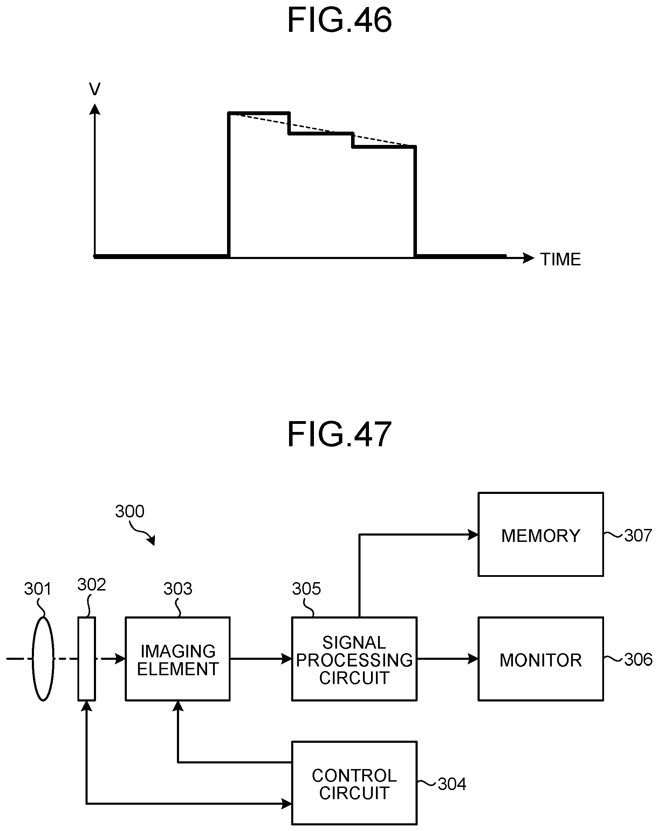

FIGS. 42 to 46 are diagrams each illustrating an example of a shape of a non-rectangular pulse. Note that FIGS. 42 to 46 illustrate the case of writing of the state 1. In the case of writing of the state 0, the voltage increases with time. In FIG. 42, the voltage shape linearly depends on time. In FIG. 43, the voltage shape is convex downward. In FIG. 44, the voltage shape is convex upward. In FIGS. 45 and 46, the voltage shape is formed into a non-rectangular pulse by a plurality of rectangular pulses. Such FIGS. 42 to 46 illustrate examples of the shapes of the non-rectangular pulse, and it is not limited thereto.

Here, in FIGS. 42 to 46, a pulse waveform has a shape in which an amplitude changes from 0 to a desired amplitude value, gradually decreases from the desired amplitude value to another amplitude value, and changes from the another amplitude value to 0. This pulse waveform has a shape that decreases linearly, curvilinearly, or stepwise from the desired amplitude value to the another amplitude value. This shape is the case of writing of the state 1, and in the case of writing of the state 0, the pulse waveform is a shape that increases linearly, curvilinearly, or stepwise from the desired amplitude value and becomes the another amplitude value.

### <11. Configuration Example of Electronic Device>

As an electronic device to which the memory system 1 according to the above embodiment (including modifications) is applied, an imaging device 300, a distance measuring device 400, and a game apparatus 900 will be described with reference to FIGS. 47 to 50. For example, each of the imaging device 300, the distance measuring device 400, and the game apparatus 900 uses the memory system 1 according to each of the above embodiments as a memory.

### <11-1. Imaging Device>

The imaging device 300 to which the memory system 1 according to the above embodiment is applied will be described with reference to FIG. 47. FIG. 47 is a diagram illustrating an example of a schematic configuration of the imaging device 300. The imaging device 300 is an example of the electronic device to which the memory system 1 according to the present embodiment is applied. Examples of the imaging device 300 include electronic devices such as a digital still camera, a video camera, a smartphone having an imaging function, and a mobile phone.

As illustrated in FIG. 47, the imaging device 300 includes an optical system 301, a shutter device 302, an imaging element 303, a control circuit (drive circuit) 304, a signal processing circuit 305, a monitor 306, and a memory 307. The imaging device 300 can capture a still image and a moving image.

The optical system 301 includes one or a plurality of lenses. The optical system 301 guides light (incident light) from a subject to the imaging element 303 and forms an image on a light receiving surface of the imaging element 303.

The shutter device 302 is disposed between the optical system 301 and the imaging element 303. The shutter device 302 controls a light irradiation period and a light shielding period with respect to the imaging element 303 according to the control of the control circuit 304.

The imaging element 303 accumulates signal charges for a certain period according to light formed on the light receiving surface via the optical system 301 and the shutter device 302. The signal charges accumulated in the imaging element 303 is transferred in accordance with a drive signal (timing signal) supplied from the control circuit 304.

The control circuit 304 outputs the drive signal for controlling a transfer operation of the imaging element 303 and a shutter operation of the shutter device 302 to drive the imaging element 303 and the shutter device 302.

The signal processing circuit 305 performs various types of signal processing on the signal charges output from the imaging element 303. An image (image data) obtained by performing the signal processing by the signal processing circuit 305 is supplied to the monitor 306 and also supplied to the memory 307. The signal processing circuit 305 corresponds to the arithmetic circuit 2 according to the above embodiment.

The monitor 306 displays a moving image or a still image captured by the imaging element 303 based on the image data supplied from the signal processing circuit 305. As the monitor 306, for example, a panel type display device such as a liquid crystal panel or an organic electro luminescence (EL) panel is used.

The memory 307 stores the image data supplied from the signal processing circuit 305, that is, image data of the moving image or the still image captured by the imaging element 303. The memory 307 corresponds to the memory device 1 according to the above embodiment.

Also in the imaging device 300 configured in this manner, low-power-consumption writing can be implemented by using the above-described memory system 1 as the memory 307.

### <11-2. Distance Measuring Device>

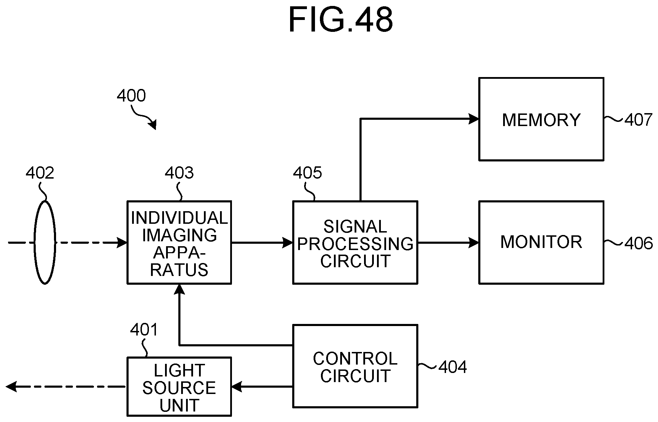

The distance measuring device 400 to which the memory system 1 according to the above embodiment is applied will be described with reference to FIG. 48. FIG. 48 is a diagram illustrating an example of a schematic configuration of the distance measuring device 400. The distance measuring device 400 is an example of the electronic device to which the memory system 1 according to the present embodiment is applied.

As illustrated in FIG. 48, the distance measuring device (distance image sensor) 400 includes a light source unit 401, an optical system 402, a solid-state imaging device (imaging element) 403, a control circuit (drive circuit) 404, a signal processing circuit 405, a monitor 406, and a memory 407. The distance measuring device 400 can acquire a distance image according to a distance to a subject by projecting light from the light source unit 401 toward the subject and receiving light (modulated light or pulsed light) reflected from a surface of the subject.

The light source unit 401 projects light toward the subject. As the light source unit 401, for example, a vertical cavity surface emitting laser (VCSEL) array that emits laser light as a surface light source or a laser diode array in which laser diodes are arrayed on a line is used. Note that the laser diode array is supported by a predetermined drive unit (not illustrated), and is scanned in a direction perpendicular to the array direction of the laser diodes.

The optical system 402 includes one or a plurality of lenses. The optical system 402 guides light (incident light) from the subject to the solid-state imaging device 403 to form an image on a light receiving surface (sensor unit) of the solid-state imaging device 403.

The solid-state imaging device 403 stores signal charges according to the light of the image formed on the light receiving surface via the optical system 402. A distance signal indicating the distance obtained from a light reception signal (APD OUT) output from the solid-state imaging device 403 is supplied to the signal processing circuit 405. As the solid-state imaging device 403, for example, a solid-state imaging element such as an image sensor is used.

The control circuit 404 outputs a drive signal (control signal) for controlling operations of the light source unit 401, the solid-state imaging device 403, and the like to drive the light source unit 401, the solid-state imaging device 403, and the like.

The signal processing circuit 405 performs various types of signal processing on the distance signal supplied from the solid-state imaging device 403. For example, the signal processing circuit 405 performs image processing (for example, histogram processing, peak detection processing, and the like) of constructing the distance image on the basis of the distance signal. An image (image data) obtained by performing the signal processing by the signal processing circuit 405 is supplied to the monitor 406 and also supplied to the memory 407. The signal processing circuit 405 corresponds to the arithmetic circuit 2 according to the above embodiment.

The monitor 406 displays the distance image captured by the solid-state imaging device 403 on the basis of the image data supplied from the signal processing circuit 405. As the monitor 406, for example, a panel type display device such as a liquid crystal panel or an organic EL panel is used.

The memory 407 stores the image data supplied from the signal processing circuit 405, that is, the image data of the distance image captured by the solid-state imaging device 403. The memory 407 corresponds to the memory system 1 according to the above embodiment.

Also in the distance measuring device 400 configured in this manner, low-power-consumption writing can be implemented by using the above-described memory system 1 as the memory 407.

### <11-3. Game Device>

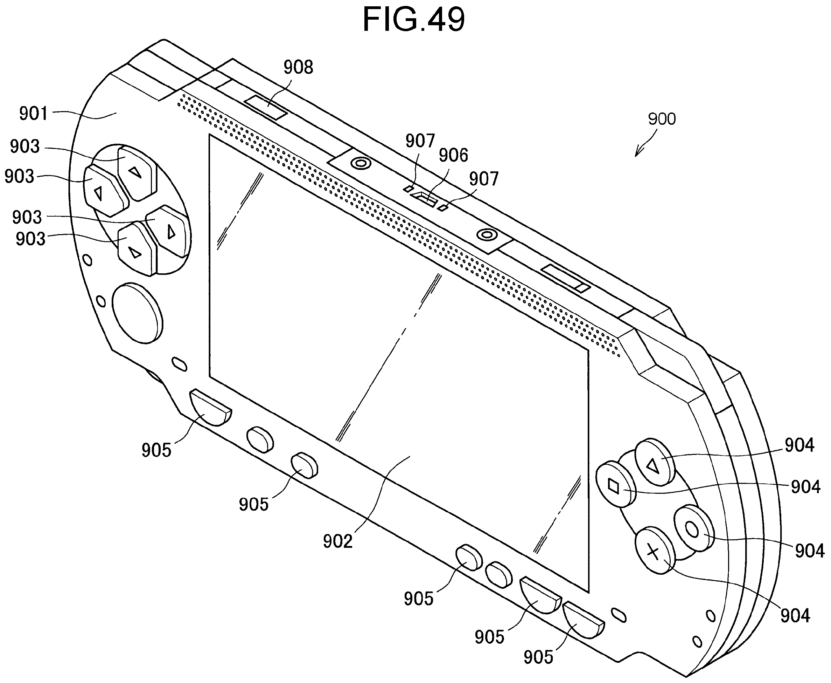

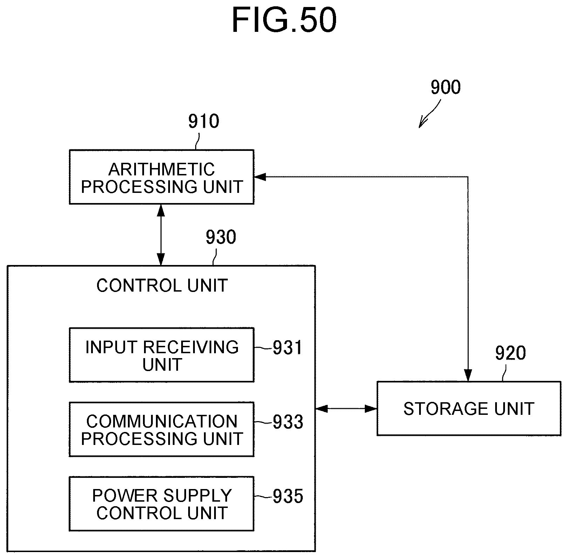

The game device 900 to which the memory system 1 according to the above embodiment is applied will be described with reference to FIGS. 49 and 50. FIG. 49 is a perspective view (external perspective view) illustrating an example of the schematic configuration of the game device 900. FIG. 50 is a block diagram illustrating an example of the schematic configuration of the game device 900. The game device 900 is an example of the electronic device to which the memory system 1 according to the present embodiment is applied.

As illustrated in FIG. 49, for example, the game device 900 has an appearance in which each component is disposed inside and outside an outer casing 901 formed in a horizontally long flat shape.

On the front surface of the outer casing 901, a display panel 902 is provided at the center thereof in the longitudinal direction. Further, operation keys 903 and operation keys 904 are provided on the left and right sides of the display panel 902, respectively, spaced apart from each other in the circumferential direction. An operation key 905 is provided at a lower end of the front surface of the outer casing 901. The operation keys 903, 904, and 905 function as direction keys, determination keys, or the like, and are used for selection of menu items displayed on the display panel 902, progress of a game, or the like.

On the upper surface of the outer casing 901, a connection terminal 906 for connecting an external device, a power supply terminal 907, a light receiving window 908 for performing infrared communication with the external device, and the like are provided.

As illustrated in FIG. 50, the game device 900 includes an arithmetic processing unit 910 including a central processing unit (CPU), a storage unit 920 that stores various types of information, and a controller 930 that controls each configuration of the game device 900. Power is supplied to the arithmetic processing unit 910 and the controller 930 from, for example, a battery (not illustrated) or the like.

The arithmetic processing unit 910 generates a menu screen for allowing a user to set various types of information or select an application. In addition, the arithmetic processing unit 910 executes the application selected by the user. The arithmetic processing unit 910 corresponds to the arithmetic circuit 2 according to the above embodiment.

The storage unit 920 stores various types of information set by the user. The storage unit 920 corresponds to the memory system 1 according to the above embodiment.

The controller 930 includes an input receiving unit 931, a communication processing unit 933, and a power controller 935. The input receiving unit 931 detects, for example, the states of the operation keys 903, 904, and 905. Furthermore, the communication processing unit 933 performs communication processing with an external device. The power controller 935 controls power supplied to each unit of the game device 900.

Also in the game device 900 configured in this manner, low-power-consumption writing can be implemented by using the above-described memory system 1 as the storage unit 920.

It is noted that the memory system 1 according to each of the above-described embodiments may be mounted on the same semiconductor chip together with a semiconductor circuit forming an arithmetic device or the like to form a semiconductor device (System-on-a-Chip: SoC).

Furthermore, the memory system 1 according to the above embodiment can be mounted on various electronic devices on which a memory (storage unit) can be mounted as described above. For example, the memory system 1 may be mounted on various electronic devices such as a hard disk drive (HDD), a notebook personal computer (PC), a mobile device (for example, a smartphone, a tablet PC, or the like), a personal digital assistant (PDA), a wearable device, and a music device in addition to the imaging device 300 and the game device 900. For example, the memory system 1 is used as various memories such as a storage.

### <12. Appendix>

Note that the present technique can also have the following configurations.
(1) A storage device comprising:
   a first magnetoresistive element that has a magnetization direction variable by voltage application and has a first retention force for retaining the magnetization direction;
   a second magnetoresistive element that has a magnetization direction variable by voltage application and has a second retention force for retaining the magnetization direction, the second retention force being lower than the first retention force; and
   a write unit that applies a voltage to the first magnetoresistive element by a first writing method and applies a voltage to the second magnetoresistive element by a second writing method different from the first writing method.
(2) The storage device according to (1), wherein
   the write unit includes
   a voltage generation circuit that generates a voltage,
   a first write circuit that applies the voltage generated by the voltage generation circuit to the first magnetoresistive element by the first writing method, and
   a second write circuit that applies the voltage generated by the voltage generation circuit to the second magnetoresistive element by the second writing method.
(3) The storage device according to (1), wherein
   the write unit includes
   a first voltage generation circuit that generates a first voltage,
   a second voltage generation circuit that generates a second voltage,
   a first write circuit that applies the first voltage generated by the first voltage generation circuit to the first magnetoresistive element by the first writing method, and
   a second write circuit that applies the second voltage generated by the second voltage generation circuit to the second magnetoresistive element by the second writing method.
(4) The storage device according to (2), wherein
   the write unit further includes
   a plurality of error correction processing circuits or one error correction processing circuit provided for both or one of the first write circuit and the second write circuit and configured to detect and correct an error in information.
(5) The storage device according to (3), wherein
   the write unit further includes
   a plurality of error correction processing circuits or one error correction processing circuit provided for both or one of the first write circuit and the second write circuit and configured to detect and correct an error in information.
(6) The storage device according to any one of (1) to (5), wherein
   the first writing method is a method of applying, to the first magnetoresistive element, a voltage that makes the first retention force of the first magnetoresistive element during voltage application smaller than that before voltage application and larger than 0, and
   the second writing method is a method of applying, to the second magnetoresistive element, a voltage that makes the second retention force of the second magnetoresistive element during voltage application 0.
(7) The storage device according to any one of (1) to (6), wherein
   a pulse width of the voltage applied to the first magnetoresistive element is different from a pulse width of the voltage applied to the second magnetoresistive element.
(8) The storage device according to (7), wherein
   the pulse width of the voltage applied to the second magnetoresistive element is shorter than the pulse width of the voltage applied to the first magnetoresistive element.
(9) The storage device according to any one of (1) to (8), wherein
   in a case where a magnetic direction of the first magnetoresistive element is not in a desired state after applying a voltage to the first magnetoresistive element by the first writing method, the write unit applies a voltage to the first magnetoresistive element again by the first writing method.
(10) The storage device according to (9), wherein
   in a case where a magnetic direction of the first magnetoresistive element is not in the desired state after applying a voltage to the first magnetoresistive element by the first writing method, the write unit applies a voltage to the first magnetoresistive element again by the first writing method, in response to an instruction signal instructing rewriting to the first magnetoresistive element.
(11) The storage device according to any one of (1) to (10), wherein
   the write unit changes a pulse width of the voltage applied to the first magnetoresistive element or the second magnetoresistive element, in response to an instruction signal instructing a change of the pulse width of the voltage.
(12) An electronic device comprising:
   a storage device that stores information, wherein
   the storage device includes
      a first magnetoresistive element that has a magnetization direction variable by voltage application and has a first retention force for retaining the magnetization direction,
      a second magnetoresistive element that has a magnetization direction variable by voltage application and has a second retention force for retaining the magnetization direction, the second retention force being lower than the first retention force, and
      a write unit that applies a voltage to the first magnetoresistive element by a first writing method and applies a voltage to the second magnetoresistive element by a second writing method different from the first writing method.
(13) A storage device control method comprising:
   applying a voltage by a first writing method to a first magnetoresistive element that has a magnetization direction variable by voltage application and has a first retention force for retaining the magnetization direction; and
   applying a voltage by a second writing method different from the first writing method to a second magnetoresistive element that has a magnetization direction variable by voltage application and has a second retention force for retaining the magnetization direction, the second retention force being lower than the first retention force.
(14) An electronic device including the storage device according to any one of (1) to (11).
(15) A storage device control method for controlling the storage device according to any one of (1) to (11).

### Reference Signs List

- 1: MEMORY SYSTEM
- 2: ARITHMETIC CIRCUIT
- 3: STORAGE DEVICE
- 3a: STORAGE CIRCUIT
- 3b: STORAGE CIRCUIT
- 3c: VOLTAGE GENERATION CIRCUIT
- 3c1: VOLTAGE GENERATION CIRCUIT
- 3c2: VOLTAGE GENERATION CIRCUIT
- 10A: HIGH-RETENTION MEMORY CELL ARRAY
- 10B: LOW-RETENTION MEMORY CELL ARRAY
- 11: WORD LINE
- 12: BIT LINE
- 13: SOURCE LINE
- 20: WORD LINE CONTROL CIRCUIT
- 30: BIT LINE CONTROL CIRCUIT
- 40: SENSE AMPLIFIER
- 50: READ CIRCUIT
- 60: WRITE CIRCUIT
- 60A: HIGH-RETENTION ELEMENT WRITE CIRCUIT
- 60B: LOW-RETENTION ELEMENT WRITE CIRCUIT
- 80: ECC PROCESSING CIRCUIT
- 81: ENCODING CIRCUIT
- 82: DECODING CIRCUIT
- 100: MEMORY CELL
- 101: WIRING
- 102: WIRING
- 103: CONTACT LAYER
- 104: CONTACT LAYER
- 110: SELECTION ELEMENT
- 120: MAGNETORESISTIVE ELEMENT
- 121: UNDERLAYER
- 122: MAGNETIZATION FIXED LAYER
- 123: TUNNEL BARRIER LAYER
- 124: STORAGE LAYER
- 125: CAP LAYER
- 300: IMAGING DEVICE
- 305: SIGNAL PROCESSING CIRCUIT
- 307: MEMORY
- 400: DISTANCE MEASURING DEVICE
- 405: SIGNAL PROCESSING CIRCUIT
- 407: MEMORY
- 900: GAME DEVICE
- 910: ARITHMETIC PROCESSING UNIT
- 920: STORAGE UNIT

## Claims

1. A storage device comprising:
a first magnetoresistive element that has a magnetization direction variable by voltage application and has a first retention force for retaining the magnetization direction;
a second magnetoresistive element that has a magnetization direction variable by voltage application and has a second retention force for retaining the magnetization direction, the second retention force being lower than the first retention force; and
a write unit that applies a voltage to the first magnetoresistive element by a first writing method and applies a voltage to the second magnetoresistive element by a second writing method different from the first writing method.

2. The storage device according to claim 1, wherein
the write unit includes
a voltage generation circuit that generates a voltage,
a first write circuit that applies the voltage generated by the voltage generation circuit to the first magnetoresistive element by the first writing method, and
a second write circuit that applies the voltage generated by the voltage generation circuit to the second magnetoresistive element by the second writing method.

3. The storage device according to claim 1, wherein
the write unit includes
a first voltage generation circuit that generates a first voltage,
a second voltage generation circuit that generates a second voltage,
a first write circuit that applies the first voltage generated by the first voltage generation circuit to the first magnetoresistive element by the first writing method, and
a second write circuit that applies the second voltage generated by the second voltage generation circuit to the second magnetoresistive element by the second writing method.

4. The storage device according to claim 2, wherein
the write unit further includes
a plurality of error correction processing circuits or one error correction processing circuit provided for both or one of the first write circuit and the second write circuit and configured to detect and correct an error in information.

5. The storage device according to claim 3, wherein
the write unit further includes
a plurality of error correction processing circuits or one error correction processing circuit provided for both or one of the first write circuit and the second write circuit and configured to detect and correct an error in information.

6. The storage device according to claim 1, wherein
the first writing method is a method of applying, to the first magnetoresistive element, a voltage that makes the first retention force of the first magnetoresistive element during voltage application smaller than that before voltage application and larger than 0, and
the second writing method is a method of applying, to the second magnetoresistive element, a voltage that makes the second retention force of the second magnetoresistive element during voltage application 0.

7. The storage device according to claim 1, wherein
a pulse width of the voltage applied to the first magnetoresistive element is different from a pulse width of the voltage applied to the second magnetoresistive element.

8. The storage device according to claim 7, wherein
the pulse width of the voltage applied to the second magnetoresistive element is shorter than the pulse width of the voltage applied to the first magnetoresistive element.

9. The storage device according to claim 1, wherein
in a case where a magnetic direction of the first magnetoresistive element is not in a desired state after applying a voltage to the first magnetoresistive element by the first writing method, the write unit applies a voltage to the first magnetoresistive element again by the first writing method.

10. The storage device according to claim 9, wherein
in a case where a magnetic direction of the first magnetoresistive element is not in the desired state after applying a voltage to the first magnetoresistive element by the first writing method, the write unit applies a voltage to the first magnetoresistive element again by the first writing method, in response to an instruction signal instructing rewriting to the first magnetoresistive element.

11. The storage device according to claim 1, wherein
the write unit changes a pulse width of the voltage applied to the first magnetoresistive element or the second magnetoresistive element, in response to an instruction signal instructing a change of the pulse width of the voltage.

12. An electronic device comprising:
a storage device that stores information, wherein
the storage device includes
a first magnetoresistive element that has a magnetization direction variable by voltage application and has a first retention force for retaining the magnetization direction,
a second magnetoresistive element that has a magnetization direction variable by voltage application and has a second retention force for retaining the magnetization direction, the second retention force being lower than the first retention force, and
a write unit that applies a voltage to the first magnetoresistive element by a first writing method and applies a voltage to the second magnetoresistive element by a second writing method different from the first writing method.

13. A storage device control method comprising:
applying a voltage by a first writing method to a first magnetoresistive element that has a magnetization direction variable by voltage application and has a first retention force for retaining the magnetization direction; and
applying a voltage by a second writing method different from the first writing method to a second magnetoresistive element that has a magnetization direction variable by voltage application and has a second retention force for retaining the magnetization direction, the second retention force being lower than the first retention force.
